# EUROPEAN PATENT APPLICATION

(11) **EP 4 661 615 A1**
(43) Date of publication of application: **10.12.2025**
(21) Application number: 25176823.0
(22) Date of filing: 15.05.2025
(51) Int. Cl.: H10B 12/00

(54) **METHOD FOR MANUFACTURING SEMICONDUCTOR MEMORY DEVICE**

(30) Priority: 05.06.2024 KR 20240073419
(71) Applicant: Samsung Electronics Co., Ltd., Suwon-si, Gyeonggi-do 16677 (KR)
(72) Inventor: CHOI, Jin Seo, 16677 Suwon-si (KR)
(74) Representative: Marks & Clerk LLP

(57) **Abstract**

A method for manufacturing a semiconductor memory device comprises providing a substrate including a cell area and a peripheral area; forming a peripheral gate structure on the peripheral area of the substrate; forming bit-line structures on the cell area of the substrate; forming cell line spacers on sidewalls of the bit-line structures; forming a storage contact in a space between adjacent ones of the cell line spacers, wherein the storage contact is electrically connected to the substrate; forming a capping pattern on at least one of the bit-line structures, at least one of the cell line spacers, the storage contact, and the peripheral gate structure; patterning the capping pattern to form a hole exposing at least a portion of the storage contact; and forming a storage pad in the hole.

## Description

### BACKGROUND

The present disclosure relates to a method for manufacturing a semiconductor memory device.

Modern semiconductor memory devices have an increasingly higher integration level. Thus, in order to implement more semiconductor elements in the same area, individual circuit patterns are increasingly smaller. In other words, as the integration level of the semiconductor memory device increases, a design rule for components of the semiconductor memory device is decreasing.

In a highly scaled semiconductor memory device, a process of forming a plurality of wire lines and a plurality of buried contacts (BC) interposed between the lines is becoming increasingly complex and difficult. There is therefore a desire to reduce the difficulty of the production process.

### SUMMARY OF THE INVENTION

A technical purpose of the present disclosure is to provide a method for manufacturing a semiconductor memory device that may manufacture the semiconductor memory device having improved reliability and performance.

Purposes in accordance with the present disclosure are not limited to the above-mentioned purpose. Other purposes and advantages in accordance with the present disclosure that are not mentioned above may be understood from the following descriptions and more clearly understood from embodiments in accordance with the present disclosure. Further, it will be readily appreciated that the purposes and advantages in accordance with the present disclosure may be realized by features and combinations thereof as disclosed in the claims.

According to some embodiments of the present disclosure, a method for manufacturing a semiconductor memory device comprises providing a substrate including a cell area and a peripheral area; forming a peripheral gate structure on the peripheral area of the substrate; forming bit-line structures on the cell area of the substrate, wherein the bit-line structures are arranged in a first direction and extend in a second direction intersecting the first direction; forming cell line spacers on sidewalls of the bit-line structures; forming a storage contact in a space between ones of the cell line spacers adjacent to each other in the first direction, wherein the storage contact is electrically connected to the substrate; forming a capping pattern on at least one of the bit-line structures, at least one of the cell line spacers, the storage contact, and the peripheral gate structure; patterning the capping pattern to form a hole exposing at least a portion of the storage contact; and forming a storage pad in the hole.

According to some embodiments of the present disclosure, a method for manufacturing a semiconductor memory device comprises forming bit-line structures on a substrate, wherein the bit-line structures are arranged in a first direction and extend in a second direction intersecting the first direction; forming a contact trench between ones of the bit-line structures to expose the substrate; forming a storage contact in the contact trench; forming a capping pattern on at least one of the bit-line structures and the storage contact; patterning the capping pattern to form a hole exposing at least a portion of the storage contact; and forming a storage pad in the hole.

According to some embodiments of the present disclosure, a method for manufacturing a semiconductor memory device comprises providing a substrate including a cell area and a peripheral area; forming a peripheral gate structure on the peripheral area of the substrate; forming cell gate structures in the cell area of the substrate, wherein the cell gate structures extend in a first direction and are arranged in a second direction intersecting the first direction; forming bit-line structures on the cell area of the substrate, wherein the bit-line structures are arranged in the first direction and extend in the second direction; forming cell line spacers on sidewalls of the bit-line structures; forming a storage contact in a space between ones of the cell gate structures adjacent to each other in the second direction and a space between ones of the cell line spacers adjacent to each other in the first direction, wherein the storage contact is electrically connected to the substrate; forming a capping pattern on at least one of the bit-line structures, at least one of the cell line spacers, the storage contact, and the peripheral gate structure; patterning the capping pattern to form a hole exposing at least a portion of the storage contact; forming a storage pad in the hole and on an upper surface of a portion of the capping pattern in the cell area; forming a pad isolation pattern adjacent to the storage pad; and forming a data storage pattern on the storage pad to be electrically connected to the storage pad.

At least some of the above and other features of the invention are set out in the claims.

### BRIEF DESCRIPTION OF DRAWINGS

The above and other aspects and features of the present disclosure will become more apparent by describing in detail illustrative embodiments thereof with reference to the attached drawings, in which:
FIG. 1 is a schematic layout diagram of a semiconductor memory device according to some embodiments;
FIG. 2 is a layout diagram illustrating a cell area and a peripheral area of FIG. 1;
FIG. 3 is a cross-sectional view cut along lines A-A' and B-B' in FIG. 2;
FIG. 4 is a cross-sectional view cut along line C-C' in FIG. 2;
FIGS. 5 to 24 are diagrams of intermediate structures corresponding to intermediate steps for illustrating a method for manufacturing a semiconductor memory device according to some embodiments;
FIGS. 25 and 26 are various cross-sectional views illustrating a semiconductor memory device according to some embodiments;
FIGS. 27 to 39 are diagrams of intermediate structures corresponding to intermediate steps for illustrating a method for manufacturing a semiconductor memory device according to some embodiments;
FIGS. 40 and 41 are various cross-sectional views illustrating a semiconductor memory device according to some embodiments; and
FIGS. 42 to 44 are diagrams of intermediate structures corresponding to intermediate steps for illustrating a method for manufacturing a semiconductor memory device according to some embodiments.

### DETAILED DESCRIPTION

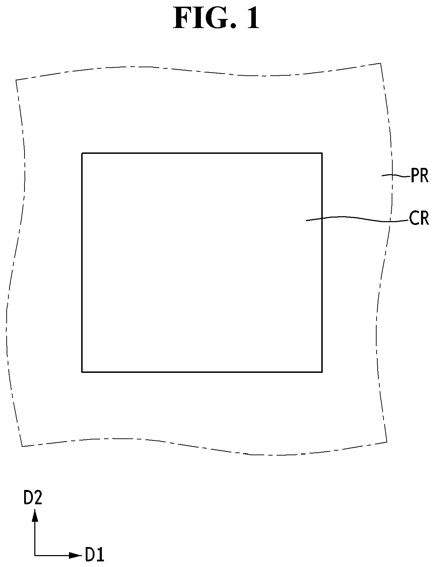

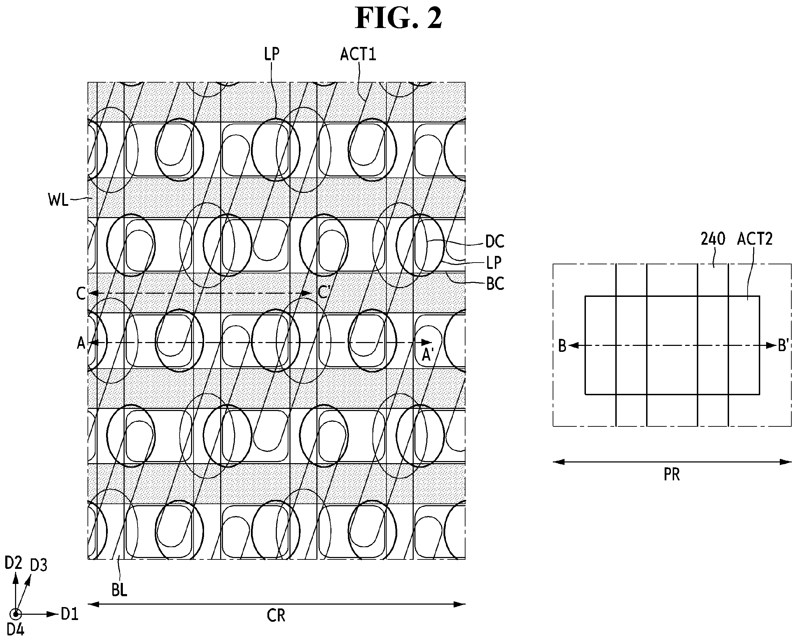

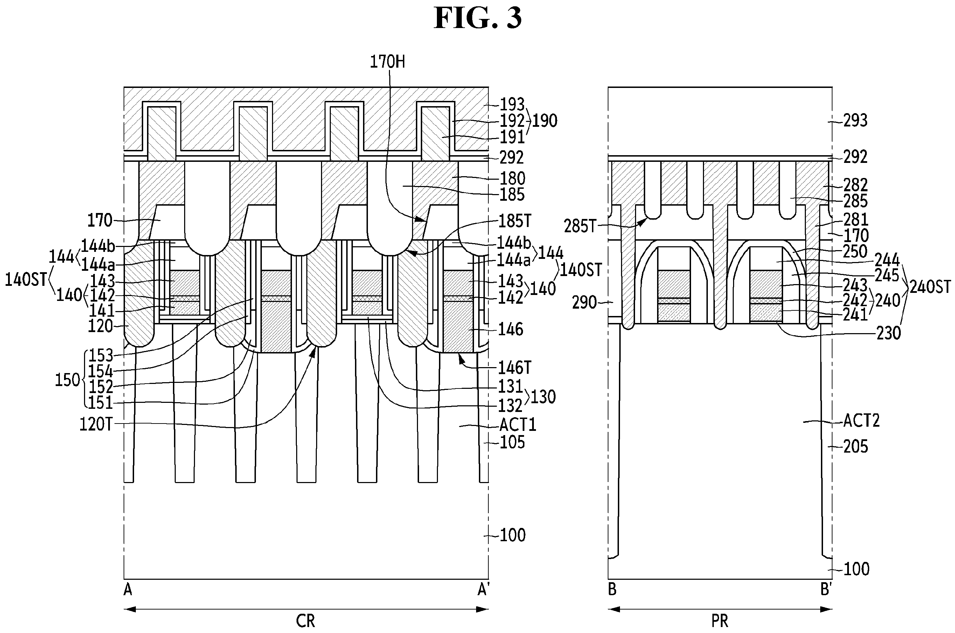

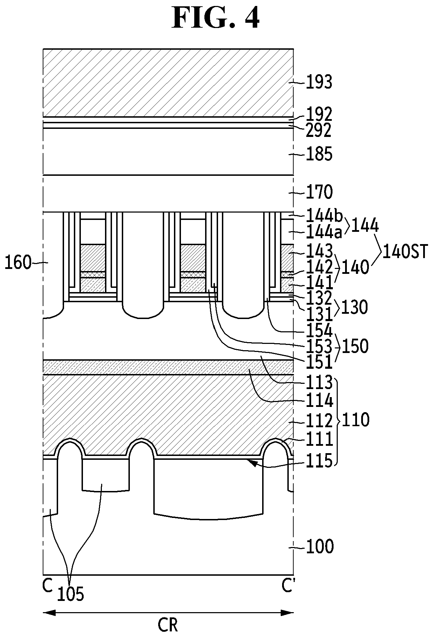

FIG. 1 is a schematic layout diagram of a semiconductor memory device according to some embodiments. FIG. 2 is a layout diagram illustrating a cell area and a peripheral area of FIG. 1. FIG. 3 is a cross-sectional view cut along lines A-A' and B-B' in FIG. 2. FIG. 4 is a cross-sectional view cut along line C-C' in FIG. 2.

Referring to FIGS. 1 to 4, a semiconductor memory device according to some embodiments may include a cell area CR and a peripheral area PR.

The cell area CR may be a memory cell array area where memory cells are disposed. The peripheral area PR may be a core/peripheral area disposed around the cell area CR. Some control elements and dummy elements may be formed in the peripheral area PR to control a function of the memory cells formed in the cell area CR. The cell area CR and the peripheral area PR may be arranged in various forms. For example, the peripheral area PR may be formed along a perimeter of the cell area CR.

The cell area CR may include a plurality of cell active areas ACT1. The cell active area ACT1 may be defined by a cell element isolation film 105 formed in a substrate 100. As the design rule of the semiconductor memory device decreases, the cell active area ACT1 may have a bar shape extending in a diagonal line or an oblique line, as shown in FIG. 2. For example, the cell active area ACT1 may extend in a third direction D3. The direction D3 may cross directions D1, D2 of the plane of Figures 1 and 2. It will be understood that these directions are examples, expressed relative to a device and do not imply any particular orientation of that device.

Each of a plurality of gate electrodes may extend in a first direction D1 and across the cell active area ACT1. The plurality of gate electrodes may extend parallel to each other. Each of the plurality of gate electrodes may be embodied as, for example, each of a plurality of word-lines WL. The word-lines WL may be spaced from each other by an equal spacing. A width of the word-line WL or a spacing between word-lines WL may be determined according to the design rule.

A plurality of bit-lines BL extending in a second direction D2 perpendicular to the extension direction of the word-line WL may be disposed on the word-lines WL. The plurality of bit-lines BL may extend parallel to each other. The bit-lines BL may be arranged to be spaced from each other by the same spacing. A width of the bit-line BL or a spacing between bit-lines BLs may be determined according to the design rule.

A semiconductor memory device according to some embodiments may include various contact arrangements formed on the cell active area ACT1. The various contact arrangements may include, for example, a direct contact DC, a buried contact BC, and a landing pad LP, etc.

In this regard, the direct contact DC may mean a contact that electrically connects the cell active area ACT1 to the bit-line BL. The buried contact BC may mean a contact connecting the cell active area ACT1 to a lower electrode 191 of a capacitor. In terms of an arrangement structure, a contact area between the buried contact BC and the cell active area ACT1 may be small. Accordingly, a conductive landing pad LP may be introduced to expand the contact area between the cell active area ACT1 and the buried contact BC, and to expand the contact area between the buried contact BC and the lower electrode 191 of the capacitor.

The landing pad LP may be disposed between the cell active area ACT1 and the buried contact BC and may be disposed between the buried contact BC and the lower electrode 191 of the capacitor. In the semiconductor memory device according to some embodiments, the landing pad LP may be disposed between the buried contact BC and the lower electrode 191 of the capacitor. Expanding the contact area via the introduction of the landing pad LP may allow a contact resistance between the cell active area ACT1 and the lower electrode 191 of the capacitor to be reduced.

The direct contact DC may be connected to a center portion of the cell active area ACT1. The buried contact BC may be connected to each of both opposing ends of the cell active area ACT1. As the buried contact BC is disposed in each of both opposing ends of the cell active area ACT1, the landing pad LP may be disposed adjacent to each of both opposing ends of the cell active area ACT1 and may partially overlap with the buried contact BC. In other words, the buried contact BC may be formed to overlap the cell active area ACT1 and a cell element isolation film 105 between adjacent word-lines WL and between adjacent bit-lines BL.

The word-line WL may be formed as a structure buried in the substrate 100. The word-line WL may extend across the cell active area ACT1 between the direct contacts DC or between the buried contacts BC. As shown, two word-lines WL may extend through one cell active area ACT1. As the cell active area ACT1 extends along the third direction D3, the extension direction of the word-line WL may have an angle smaller than 90 degrees with respective to the extension direction of the cell active area ACT1.

The direct contacts DC and the buried contacts BC may be arranged in a symmetrical manner. Accordingly, the direct contacts DC and the buried contacts BC may be arranged in a straight line along the first direction D1 and the second direction D2. Unlike the direct contact DC and the buried contact BC, the landing pads LP may be arranged in a zigzag manner in the second direction D2 which the bit-line BL extends. Further, the landing pads LP may overlap with the same portion of a side face of each bit-line BL in the first direction D1 in which the word-line WL extends. For example, each of landing pads LP in a first line may overlap the left side face of a corresponding bit-line BL, while each of the landing pads LP in a second line may overlap with a right side face of the corresponding bit-line BL.

The semiconductor memory device according to some embodiments includes a substrate 100, a cell gate structure 110, a bit-line structure 140ST, a storage contact 120, a fence pattern 160, a capping pattern 170, a storage pad 180, a pad isolation pattern 185, a data storage pattern 190, a peripheral gate structure 240ST, a peripheral contact plug 281, a peripheral wiring line 282, and a peripheral wiring isolation pattern 285.

The substrate 100 may include the cell area CR and the peripheral area PR. The substrate 100 may be a silicon substrate or may be made of an SOI (silicon-on-insulator). In other embodiments, the substrate 100 may include silicon germanium, SGOI (silicon germanium on insulator), indium antimonide, lead tellurium compound, indium arsenic, indium phosphide, gallium arsenide or gallium antimonide. However, the present disclosure is not limited thereto.

The cell gate structure 110, the bit-line structure 140ST, the storage contact 120, the fence pattern 160, the capping pattern 170, the storage pad 180, the pad isolation pattern 185, and the data storage pattern 190 may be disposed in the cell area CR. The capping pattern 170, the peripheral gate structure 240ST, the peripheral contact plug 281, the peripheral wiring line 282, and the peripheral wiring isolation pattern 285 may be disposed in the peripheral area PR.

The cell element isolation film 105 may be formed in the substrate 100 and in the cell area CR. The cell element isolation film 105 may have an STI (shallow trench isolation) structure. Such a structure may exhibit excellent element isolation ability. The cell element isolation film 105 may define the cell active area ACT1 within the cell area CR. The cell active area ACT1 defined by the cell element isolation film 105 may have an elongated island shape including a minor axis and a major axis. The cell active area ACT1 may have a diagonal extension shape to have an angle of smaller than 90 degrees with respect to the extension direction of the word-line WL horizontally flush with the cell element isolation film 105. Further, the cell active area ACT1 may have a diagonal extension shape to have an angle of smaller than 90 degrees with respect to an extension direction of the bit-line BL disposed on the cell element isolation film 105.

The cell element isolation film 105 may include, for example, at least one of a silicon oxide film, a silicon nitride film, or a silicon oxynitride film. However, the present disclosure is not limited thereto. The cell element isolation film 105 may be formed as a single insulating film, or as a stack of a plurality of insulating films.

The cell gate structure 110 may be disposed in the substrate 100 and the cell element isolation film 105. For example, the cell gate structures 110 may extend in the first direction D1 and may be arranged in the second direction D2 (e.g., may be spaced apart from each other in the second direction D2). The cell gate structure 110 may extend across the cell element isolation film 105 and the cell active area ACT1 defined by the cell element isolation film 105. The cell gate structure 110 may include a cell gate trench 115 formed in the substrate 100 and the cell element isolation film 105, a cell gate insulating film 111, a cell gate electrode 112, a cell gate capping pattern 113, and a cell gate capping conductive film 114. In this regard, the cell gate electrode 112 may act (i.e., function) as the word-line WL. Unlike what is illustrated, the cell gate structure 110 may not include the cell gate capping conductive film 114.

The cell gate trench 115 may be relatively deep within the cell element isolation film 105 and may be relatively shallow within the cell active area ACT1. A bottom surface of the cell gate electrode 112 may be curved. That is, a depth of the cell gate trench 115 in the cell element isolation film 105 may be greater than a depth of the cell gate trench 115 in the cell active area ACT1.

The cell gate insulating film 111 may extend along a sidewall and a lower surface of the cell gate trench 115. The cell gate insulating film 111 may extend along a profile of at least a portion of the cell gate trench 115. The cell gate insulating film 111 may include, for example, at least one of silicon oxide, silicon nitride, silicon oxynitride, or high dielectric constant materials having a higher dielectric constant than that of silicon oxide. The high dielectric constant material may include, for example, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, and combinations thereof.

The cell gate electrode 112 may be formed on the cell gate insulating film 111. The cell gate electrode 112 may be in (e.g., may fill) a portion of the cell gate trench 115. The cell gate capping conductive film 114 may extend along an upper surface of the cell gate electrode 112. The cell gate capping conductive film 114 is shown not covering a portion of the upper surface of the cell gate electrode 112. However, embodiments of the present disclosure are not limited thereto. As used herein, the upper surface and the lower surface are defined based on a fourth direction D4. For example, the fourth direction D4 may be perpendicular to an upper surface of the substrate 100.

The cell gate electrode 112 may include at least one of metal, conductive metal carbonitride, conductive metal carbide, metal silicide, doped semiconductor material, conductive metal oxynitride, or conductive metal oxide. The cell gate electrode 112 may include at least one of, for example, TiN, TaC, TaN, TiSiN, TaSiN, TaTiN, TiAlN, TaAlN, WN, Ru, TiAl, TiAlC-N, TiAlC, TiC, TaCN, W, Al, Cu, Co, Ti, Ta, Ni, Pt, Ni-Pt, Nb, NbN, NbC, Mo, MoN, MoC, WC, Rh, Pd, Ir, Ag, Au, Zn, V, RuTiN, TiSi, TaSi, NiSi, CoSi, IrOx, RuOx, or combinations thereof. However, the present disclosure is not limited thereto. The cell gate capping conductive film 114 may include, for example, polysilicon or polysilicon-germanium. However, the present disclosure is not limited thereto.

The cell gate capping pattern 113 may be disposed on the cell gate electrode 112 and the cell gate capping conductive film 114. The cell gate capping pattern 113 may be in (e.g., may fill) a remaining portion of the cell gate trench 115 except for the cell gate electrode 112 and the cell gate capping conductive film 114. The cell gate insulating film 111 is shown to extend along a sidewall of the cell gate capping pattern 113. However, the present disclosure is not limited thereto.

The cell gate capping pattern 113 may include, for example, at least one of silicon nitride (SiN), silicon oxynitride (SiON), silicon oxide (SiO₂), silicon carbonitride (SiCN), silicon oxycarbonitride (SiOCN), or combinations thereof.

An impurity doped area may be formed on at least one side of the cell gate structure 110. The impurity doped area may act as a source/drain area of the transistor.

The bit-line structure 140ST may include a cell conductive line 140 and a cell line capping film 144. The cell conductive line 140 may be disposed on the substrate 100 and the cell element isolation film 105 in an area in which the cell gate structure 110 is disposed. For example, the bit-line structures 140ST may be arranged in the first direction D1 (e.g., may be spaced apart from each other in the first direction D1) and may extend in the second direction D2.

The cell conductive line 140 may extend in the second direction D2. The cell conductive line 140 may intersect the cell element isolation film 105, and the cell active area ACT1 defined by the cell element isolation film 105. The cell conductive line 140 may be formed to intersect with the cell gate structure 110. In this regard, the cell conductive line 140 may act (i.e., function) as the bit-line BL.

The cell conductive line 140 may be embodied as a multi-film. The cell conductive line 140 may include, for example, a first cell conductive film 141, a second cell conductive film 142, and a third cell conductive film 143. The first to third cell conductive films 141, 142, and 143 may be sequentially stacked on the substrate 100 and the cell element isolation film 105. Although the cell conductive line 140 is shown to include three films, the present disclosure is not limited thereto.

Each of the first to third cell conductive films 141, 142, and 143 may include, for example, at least one of a semiconductor material doped with impurities, a conductive silicide compound, a conductive metal nitride, a 2D (two-dimensional) material, or a metal. For example, the first cell conductive film 141 may include a doped semiconductor material, the second cell conductive film 142 may include at least one of the conductive silicide compound, the conductive metal nitride or the 2D material, and the third cell conductive film 143 may include the metal. However, the present disclosure is not limited thereto.

A bit-line contact 146 may be formed between the cell conductive line 140 and the substrate 100. That is, the cell conductive line 140 may be disposed on the bit-line contact 146. For example, the bit-line contact 146 may be disposed at a point where the cell conductive line 140 intersects a center portion of the cell active area ACT1 having an elongated island shape. The bit-line contact 146 may be disposed between the center portion of the cell active area ACT1 and the cell conductive line 140.

The bit-line contact 146 may connect the cell conductive line 140 and the cell active area ACT1 to each other. For example, a contact trench 146T may be formed in the substrate 100 so as to extend through a cell insulating film 130 to expose the center portion of the cell active area ACT1. The bit-line contact 146 may be formed in the contact trench 146T so as to electrically connect the center portion of the cell active area ACT1 and the cell conductive line 140 to each other. In this regard, the bit-line contact 146 may act (i.e., function) as the direct contact DC. The bit-line contact 146 may include, for example, at least one of a semiconductor material doped with impurities, a conductive silicide compound, a conductive metal nitride, or a metal.

In an area in which the cell conductive line 140 overlaps an upper surface of the bit-line contact 146, the cell conductive line 140 may include the second cell conductive film 142 and the third cell conductive film 143. In an area in which the cell conductive line 140 does not overlap the upper surface of the bit-line contact 146, the cell conductive line 140 may include the first to third cell conductive films 141, 142, and 143. A thickness of the cell conductive line 140 in the area in which the cell conductive line 140 overlaps with the upper surface of the bit-line contact 146 may be different from a thickness of the cell conductive line 140 in the area in which the cell conductive line 140 does not overlap with the upper surface of the bit-line contact 146.

The cell line capping film 144 may be disposed on the cell conductive line 140. The cell line capping film 144 may extend in the second direction D2 and along the upper surface of the cell conductive line 140. The cell line capping film 144 may include, for example, at least one of silicon nitride, silicon oxynitride, silicon carbonitride, or silicon oxycarbonitride.

In some embodiments, the cell line capping film 144 may include a first cell line capping film 144a and a second cell line capping film 144b. The second cell line capping film 144b may be disposed on the first cell line capping film 144a. When the first cell line capping film 144a and the second cell line capping film 144b are made of the same material, a boundary between the first cell line capping film 144a and the second cell line capping film 144b may not be defined. In other words, the cell line capping film 144 may be a monolithic film.

The cell insulating film 130 may be disposed on the substrate 100 and the cell element isolation film 105. The cell insulating film 130 may be disposed on the substrate 100 and the cell element isolation film 105 in an area in which the bit-line contact 146 is not formed. The cell insulating film 130 may be disposed between the substrate 100 and the cell conductive line 140, and between the cell element isolation film 105 and the cell conductive line 140.

The cell insulating film 130 may be a single film or a stack of multi-films. For example, the cell insulating film 130 may include a first cell insulating film 131 and a second cell insulating film 132. For example, the first cell insulating film 131 may include a silicon oxide film, and the second cell insulating film 132 may include a silicon nitride film. The cell insulating film 130 may further include a third cell insulating film including a silicon oxide film.

A cell line spacer 150 may be disposed on a longitudinal sidewall of the bit-line structure 140ST extending in an elongated manner in the second direction D2. For example, the cell line spacers 150 may be spaced apart from each other in the first direction D1.

The cell line spacer 150 may be disposed on a sidewall of each of the cell conductive line 140 and the cell line capping film 144. The cell line spacer 150 may be disposed on the substrate 100 and the cell element isolation film 105 around an area in which the cell conductive line 140 overlaps the bit-line contact 146. The cell line spacer 150 may be disposed on the sidewall of each of the cell conductive line 140, the cell line capping film 144, and the bit-line contact 146.

In an area in which the cell conductive line 140 does not overlap the bit-line contact 146, the cell line spacer 150 may be disposed on the cell insulating film 130. The cell line spacer 150 may be disposed on the sidewall of each of the cell conductive line 140 and the cell line capping film 144.

The cell line spacer 150 may be embodied as a single film or as multi-films. For example, the cell line spacer 150 may be embodied as multi-films including first to fourth cell line spacers 151, 152, 153, and 154. For example, each of the first to fourth cell line spacers 151, 152, 153, and 154 may include a silicon oxide film, a silicon nitride film, a silicon oxynitride (SiON) film, a silicon oxycarbonitride (SiOCN) film, air, and a combination thereof.

The fence pattern 160 may be disposed on the substrate 100 and the cell element isolation film 105. The fence pattern 160 may be formed to overlap the cell gate structure 110 formed in the substrate 100 and the cell element isolation film 105. The fence pattern 160 may be disposed between the bit-line structures 140ST extending in the second direction D2. For example, the fence pattern 160 may include at least one of silicon oxide, silicon nitride, silicon oxynitride, or combinations thereof.

Each of a plurality of storage contacts 120 may be disposed between adjacent ones of the cell conductive lines 140 arranged in the first direction D1. The storage contact 120 may be disposed between adjacent ones of the fence patterns 160 arranged in the second direction D2. The storage contact 120 may overlap a portion of each of the substrate 100 and the cell element isolation film 105 disposed between adjacent cell conductive lines 140.

The storage contact 120 may be connected to the cell active area ACT1. For example, a contact trench 120T may be formed within the substrate 100 so as to extend through the cell insulating film 130 to expose an end of the cell active area ACT1. The storage contact 120 may be formed in the contact trench 120T and may be electrically connected to the end of the cell active area ACT1. In this regard, the storage contact 120 may correspond to (e.g., may function as) the buried contact BC.

The storage contact 120 may be spaced apart from the cell conductive line 140 via the cell line spacer 150. The storage contact 120 may extend along a portion of an outer side surface of the cell line spacer 150.

In some embodiments, an upper surface of the storage contact 120, an upper surface of the cell line spacer 150, and an upper surface of the bit-line structure 140ST may be substantially coplanar with each other.

For example, the storage contact 120 may include at least one of a semiconductor material doped with impurities, a conductive silicide compound, a conductive metal nitride, or a metal.

The capping pattern 170 may be disposed in the cell area CR and the peripheral area PR. The capping pattern 170 may be disposed on the bit-line structure 140ST, the cell line spacer 150, and the fence pattern 160.

In some embodiments, the capping pattern 170 may be on (e.g., may cover) the upper surface of each of the bit-line structure 140ST, the cell line spacer 150, and the fence pattern 160. The capping pattern 170 may be on (e.g., may cover) an entirety of the upper surface of the cell line spacer 150. The capping pattern 170 may be disposed on a portion of the storage contact 120. The capping pattern 170 may overlap the portion of the storage contact 120 in the fourth direction D4. As used herein, "an element A overlaps an element B in a direction X" (or similar language) means that there is at least one straight line that extends in the direction X and intersects both the elements A and B. The capping pattern 170 may contact the upper surface of each of the bit-line structure 140ST, the cell line spacer 150, the fence pattern 160, and the storage contact 120.

The capping pattern 170 may include a plurality of holes 170H. The plurality of the hole 170H may be formed at locations corresponding to the plurality of storage contacts 120, respectively. The hole 170H may expose at least a portion of the upper surface of the storage contact 120. In some embodiments, the hole 170H may expose a portion of the upper surface of the storage contact 120 and may be on (e.g., may cover) the cell line spacer 150. In other embodiments, the hole 170H may expose a portion of each of the upper surface of the storage contact 120 and the upper surface of the cell line spacer 150. A portion of an upper surface of the fourth cell line spacer 154 may be exposed through the hole 170H while the upper surfaces of the second and third cell line spacers 152 and 153 may not be exposed through the hole 170H.

In some embodiments, the hole 170H may have a sloped sidewall (i.e., an inclined sidewall). A width in a direction (for example, the first direction D1 or the second direction D2) parallel to the upper surface of the substrate 100 of the hole 170H may increase as the hole extends away from the substrate 100 (along the fourth direction D4). A width of a top of the hole 170H may be larger than a width of a bottom of the hole 170H. In other words, a width in the direction (for example, the first direction D1 or the second direction D2) parallel to the upper surface of the substrate 100 of the capping pattern 170 may decrease as the capping pattern 170 extends away from the substrate 100 (along the fourth direction D4). A width of a top of the capping pattern 170 may be smaller than a width of a bottom of the capping pattern 170. In other embodiments, a sidewall of the hole 170H may be perpendicular to the upper surface of the substrate 100.

For example, the capping pattern 170 may include at least one of silicon nitride, silicon oxynitride, silicon carbonitride, or silicon oxycarbonitride. In some embodiments, the capping pattern 170 may include silicon nitride. In some embodiments, the capping pattern 170 may be a single film.

A plurality of storage pads 180 may be disposed on the storage contact 120 and the capping pattern 170. The storage pad 180 may overlap the storage contact 120 and the capping pattern 170 in the fourth direction D4. For example, a portion of the storage pad 180 may overlap with the capping pattern 170, and the other portion of the storage pad 180 may overlap with a portion of the storage contact 120.

The storage pad 180 may be in (e.g., may fill) the hole 170H. The storage pad 180 may be in contact with the storage contact 120. The storage pad 180 may be electrically connected to the storage contact 120. The storage pad 180 may be on (e.g., may cover) the capping pattern 170. The storage pad 180 may extend along an upper surface of the capping pattern 170. The storage pad 180 may be in contact with the capping pattern 170. In this regard, the storage pad 180 may correspond to (e.g., may function as) the landing pad LP.

The storage pad 180 may include a conductive material, at least one of, for example, semiconductor materials doped with impurities, conductive silicide compounds, conductive metal nitrides, conductive metal carbides, metals, or metal alloys.

The pad isolation pattern 185 may be formed on the bit-line structure 140ST, the cell line spacer 150, the capping pattern 170, and the storage pad 180. In a direction (for example, the first direction D1 or the second direction D2) parallel to the upper surface of the substrate 100, the pad isolation pattern 185 may be disposed between the capping pattern 170 and the storage pad 180.

The pad isolation pattern 185 may isolate adjacent storage pads 180 from each other. For example, a pad trench 185T (i.e., a pad isolation trench 185T) defining each of a plurality of the pad isolation patterns 185 spaced apart from each other may be formed. The pad trench 185T may extend downward from the upper surface of the storage pad 180. A vertical level of a lower surface of the pad trench 185T may be lower than that of the upper surface of the cell line capping film 144, or may be higher than that of the upper surface of the cell conductive line 140. In other words, the lower surface of the pad trench 185T may closer to the substrate 100 than the upper surface of the cell line capping film 144 is and/or may be farther away from the substrate 100 than the upper surface of the cell conductive line 140 is. A portion of the pad trench 185T may overlap with the cell line capping film 144 and the cell line spacer 150. The pad isolation pattern 185 may be in (e.g., may fill) the pad trench 185T. The pad isolation pattern 185 may not be on (e.g., may not cover) the upper surface of the storage pad 180.

The pad isolation pattern 185 may electrically isolate adjacent ones of the plurality of storage pads 180 from each other. The pad isolation pattern 185 may include an insulating material. For example, the pad isolation pattern 185 may include at least one of a silicon oxide film, a silicon nitride film, or a silicon oxynitride film.

An upper etch stop film 292 may be disposed on the pad isolation pattern 185 and the storage pad 180. The upper etch stop film 292 may extend across the cell area CR and the peripheral area PR. The upper etch stop film 292 may include at least one of a silicon nitride film, a silicon boron nitride (SiBN) film, a silicon oxynitride film, or a silicon oxycarbide film.

The data storage pattern 190 may be disposed on the storage pad 180. The data storage pattern 190 may be electrically connected to the storage pad 180. A portion of the data storage pattern 190 may be disposed within the upper etch stop film 292.

The data storage pattern 190 may include, for example, a capacitor. The data storage pattern 190 includes the lower electrode 191, a capacitor dielectric film 192, and an upper electrode 193.

The lower electrode 191 may be disposed on the storage pad 180. The lower electrode 191 may have a pillar shape, for example. In another example, the lower electrode 191 may have a cylindrical shape.

The capacitor dielectric film 192 is disposed on the lower electrode 191. The capacitor dielectric film 192 may be formed along a profile of the lower electrode 191. The upper electrode 193 is formed on the capacitor dielectric film 192. The upper electrode 193 may surround an outer wall of the lower electrode 191. The upper electrode 193 may be embodied as a single film, or a stack of multi-films.

Each of the lower electrode 191 and the upper electrode 193 may include, for example, a doped semiconductor material, a conductive metal nitride such as titanium nitride, tantalum nitride, niobium nitride or tungsten nitride, etc., a metal such as ruthenium, iridium, titanium, or tantalum, etc., or a conductive metal oxide such as iridium oxide or niobium oxide, etc. However, embodiments of the present disclosure are not limited thereto. The capacitor dielectric film 192 may include, for example, at least one of silicon oxide, silicon nitride, silicon oxynitride, a high dielectric constant material, or combinations thereof.

In another example, the data storage pattern 190 may be a variable resistance pattern that may be switched to between two resistance states under an electrical pulse applied to a memory element. For example, the data storage pattern 190 may include a phase-change material whose crystal state changes depending on an amount of current, perovskite compounds, transition metal oxides, magnetic materials, ferromagnetic materials, or antiferromagnetic materials.

A peripheral element isolation film 205 may be formed within the substrate 100 of the peripheral area PR. The peripheral element isolation film 205 may define a peripheral active area ACT2 within the peripheral area PR. For example, the peripheral element isolation film 205 may include at least one of a silicon oxide film, a silicon nitride film, or a silicon oxynitride film. The peripheral element isolation film 205 may be formed as a single insulating film, or may be formed as a stack of a plurality of insulating films.

The peripheral gate structure 240ST may be disposed on the substrate 100 in the peripheral area PR. The peripheral gate structure 240ST may be disposed on the peripheral active area ACT2 defined by the peripheral element isolation film 205.

The peripheral gate structure 240ST may include a peripheral gate insulating film 230, a peripheral gate conductive film 240, and a peripheral gate capping film 244 sequentially stacked on the substrate 100. The peripheral gate structure 240ST may include a peripheral spacer 245 disposed on a sidewall of the peripheral gate conductive film 240 and a sidewall of the peripheral gate capping film 244.

The peripheral gate conductive film 240 may include first to third peripheral conductive films 241, 242, and 243 sequentially stacked on the peripheral gate insulating film 230. In one example, an additional conductive film may not be disposed between the peripheral gate conductive film 240 and the peripheral gate insulating film 230. In another example, an additional conductive film, such as a work function conductive film, may be disposed between the peripheral gate conductive film 240 and the peripheral gate insulating film 230.

In some embodiments, the peripheral gate conductive film 240 may be formed at the same vertical level as that of the cell conductive line 140. Hereinafter, "being formed at the same vertical level" means being formed in the same manufacturing process. For example, components formed at the same vertical level may have the same material composition, but are not limited thereto. As another example, components formed at the same vertical level may have the same thickness, but are not limited thereto.

For example, the peripheral gate conductive film 240 may be formed at the same vertical level as that of the cell conductive line 140. The peripheral gate conductive film 240 and the cell conductive line 140 may have the same stack structure. A thickness of the peripheral gate conductive film 240 may be equal to a thickness of the cell conductive line 140. The first peripheral conductive film 241 may include the same material as that of the first cell conductive film 141. The second peripheral conductive film 242 may include the same material as that of the second cell conductive film 142. The third peripheral conductive film 243 may include the same material as that of the third cell conductive film 143.

The peripheral gate insulating film 230 may include, for example, silicon oxide, silicon nitride, silicon oxynitride, or a high dielectric constant material having a higher dielectric constant than that of silicon oxide.

For example, the peripheral spacer 245 may include at least one of silicon nitride, silicon oxynitride, silicon oxide, silicon carbonitride, silicon oxycarbonitride, or combinations thereof. The peripheral spacer 245 may be embodied as a single film or multi-films.

For example, the peripheral gate capping film 244 may include at least one of silicon nitride, silicon oxynitride, or silicon oxide. The peripheral gate capping film 244 may be formed at the same vertical level as a vertical level of the first cell line capping film 144a.

A lower etch stop film 250 may be disposed on the substrate 100. The lower etch stop film 250 may be formed along a profile of the peripheral gate structure 240ST. The lower etch stop film 250 may be formed at the same vertical level as a vertical level of the second cell line capping film 144b. For example, the lower etch stop film 250 may include at least one of silicon nitride, silicon oxynitride, silicon carbonitride, or silicon oxycarbonitride.

The first peripheral interlayer insulating film 290 may be disposed on the lower etch stop film 250. The first peripheral interlayer insulating film 290 may be disposed around the peripheral gate structure 240ST. For example, the first peripheral interlayer insulating film 290 may include a silicon oxide-based insulating material.

The capping pattern 170 may be disposed on the peripheral gate structure 240ST and the first peripheral interlayer insulating film 290. The capping pattern 170 may be on (e.g., may cover) the peripheral gate structure 240ST and the first peripheral interlayer insulating film 290. The capping pattern 170 may be on (e.g., may cover) a portion of the lower etch stop film 250 not covered with the first peripheral interlayer insulating film 290 so as to be exposed.

The peripheral contact plugs 281 may be respectively disposed on both opposing sides of the peripheral gate structure 240ST. The peripheral contact plug 281 may extend through the capping pattern 170 and the first peripheral interlayer insulating film 290 so as to extend to the substrate 100 of the peripheral area PR (e.g., to the peripheral active area ACT2).

The peripheral wiring line 282 may be disposed on the capping pattern 170 of the peripheral area PR. The peripheral wiring line 282 may be disposed on the peripheral gate structure 240ST. The peripheral wiring line 282 may be connected to the peripheral contact plug 281. In the cross-sectional view, when the peripheral wiring line 282 is connected to the peripheral contact plug 281, the peripheral wiring line 282 may be a portion disposed on the upper surface of the capping pattern 170. The peripheral wiring lines 282 may be disposed on the upper surface of the capping pattern 170.

Each of the peripheral contact plug 281 and the peripheral wiring line 282 may include the same material as that of the storage pad 180. The peripheral wiring isolation pattern 285 may isolate adjacent peripheral wiring lines 282 from each other.

The peripheral wiring isolation pattern 285 may isolate adjacent peripheral wiring lines 282 from each other. For example, a wiring trench 285T may be formed to define each of the peripheral wiring lines 282 that are spaced apart from each other. The wiring trench 285T may extend downward from an upper surface of the peripheral wiring line 282. A vertical level of a lower surface of the wiring trench 285T may be lower than a vertical level of the capping pattern 170, and may be higher than a vertical level of the upper surface of the peripheral gate conductive film 240. In other words, the lower surface of the wiring trench 285T may be closer to the substrate 100 than an upper surface of the capping pattern 170 is, and may be farther away from the substrate 100 than an upper surface of the peripheral gate conductive film 240 is. The peripheral wiring isolation pattern 285 may be in (e.g., may fill) the wiring trench 285T.

The peripheral wiring isolation pattern 285 may electrically isolate adjacent ones of a plurality of the peripheral wiring lines 282 from each other. The peripheral wiring isolation pattern 285 may include an insulating material. For example, the peripheral wiring isolation pattern 285 may include at least one of a silicon oxide film, a silicon nitride film, or a silicon oxynitride film. The peripheral wiring isolation pattern 285 may include the same material as that of the pad isolation pattern 185.

A second peripheral interlayer insulating film 293 may be disposed on the upper etch stop film 292. The second peripheral interlayer insulating film 293 may be on (e.g., may cover) a sidewall of the upper electrode 193. The second peripheral interlayer insulating film 293 may include an insulating material.

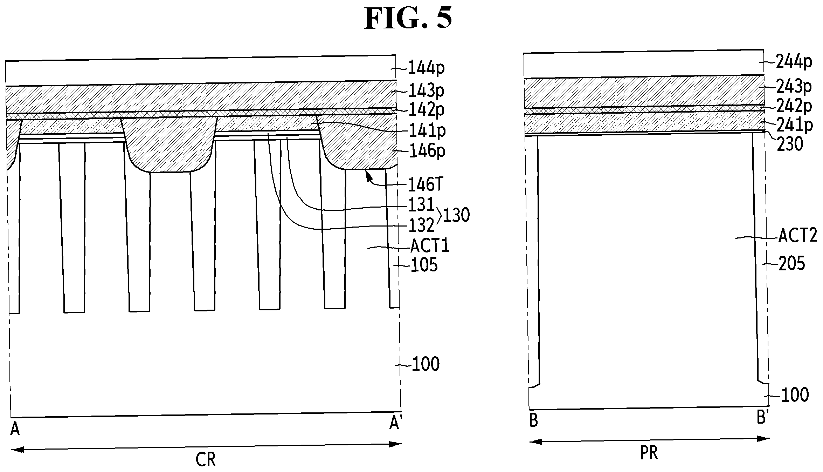

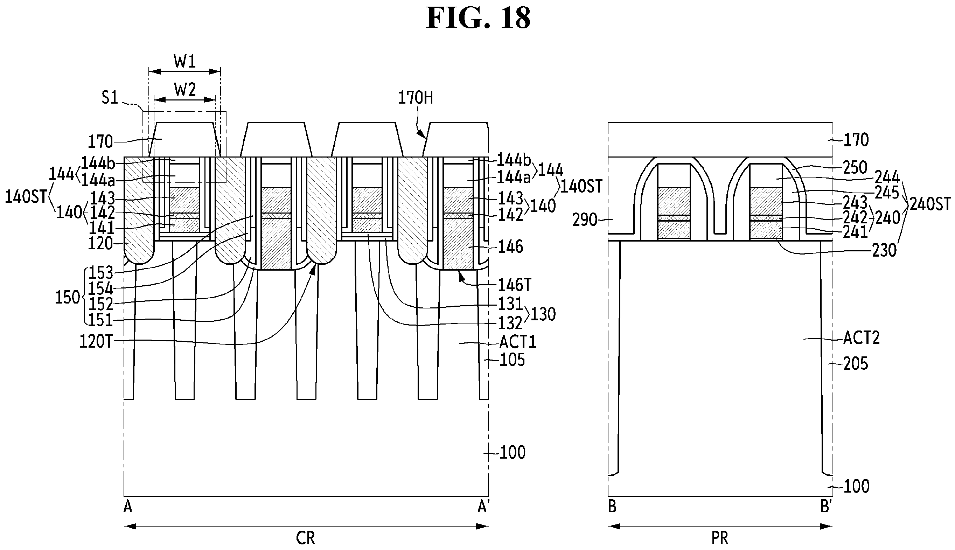

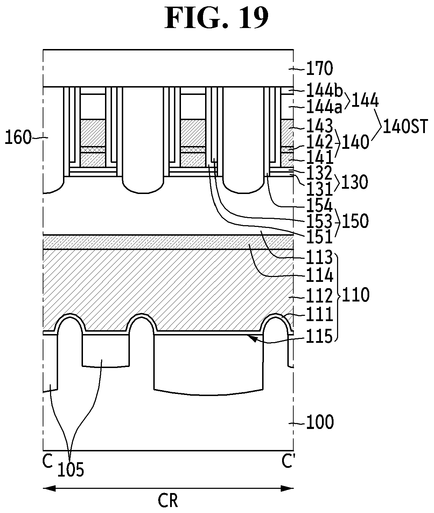

FIGS. 5 to 24 are diagrams of intermediate structures corresponding to intermediate steps for illustrating a method for manufacturing a semiconductor memory device according to some embodiments. For convenience of description, the components duplicate with those as described above with reference to FIGS. 1 to 4 are briefly described or descriptions thereof are omitted.

In some embodiments, after forming the peripheral gate structure 240ST, the bit-line structure 140ST and the storage contact 120 may be formed. Then, after forming the capping pattern 170 and the hole 170H, the storage pad 180 may be formed.

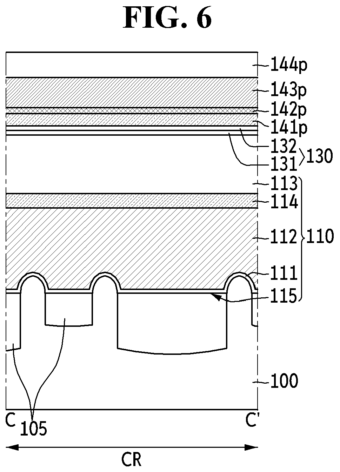

Referring to FIGS. 5 and 6, within the cell area CR of the substrate 100, the cell element isolation film 105 defining the cell active area ACT1 may be formed. Within the peripheral area PR of the substrate 100, the peripheral element isolation film 205 defining the peripheral active area ACT2 may be formed.

Subsequently, the cell gate structure 110 may be formed within the substrate 100 of the cell area CR. In other words, the cell gate structures 110 may be formed in the cell area CR of the substrate 100. The cell gate structure 110 may extend in an elongated manner in the first direction D1. For example, the cell gate structures 110 may be spaced apart from each other in the second direction D2.

Subsequently, the cell insulating film 130 may be formed in the cell area CR. The cell insulating film 130 may include the first cell insulating film 131 and the second cell insulating film 132 formed sequentially on the substrate 100. The cell insulating film 130 may not be on (e.g., may not cover) the substrate 100 of the peripheral area PR so as to be exposed. The peripheral gate insulating film 230 may be formed in the peripheral area PR.

Subsequently, a first pre-cell conductive film 141p may be formed on the cell insulating film 130, and a first pre-peripheral conductive film 241p may be formed on the peripheral gate insulating film 230. The first pre-cell conductive film 141p and the first pre-peripheral conductive film 241p may be formed at the same vertical level. Within the cell area CR, the contact trench 146T may be formed so as to expose a center area of the cell active area ACT1. A pre-direct contact 146p in (e.g., filling) the contact trench 146T may be formed. The pre-direct contact 146p may be connected to the cell active area ACT1.

Subsequently, second and third pre-cell conductive films 142p and 143p and a pre-cell line capping film 144p may be formed sequentially on the first pre-cell conductive film 141p and the pre-direct contact 146p. Second and third pre-peripheral conductive films 242p and 243p and a pre-peripheral gate capping film 244p may be formed on the first pre-peripheral conductive film 241p. The first to third pre-cell conductive films 141p, 142p, and 143p and the pre-cell line capping film 144p may be formed at the same vertical levels, respectively, as vertical levels of the first to third pre-peripheral conductive films 241p, 242p, and 243p and the pre-peripheral gate capping film 244p.

In other embodiments, after the contact trench 146T has been formed, a pre-conductive film on (e.g., covering) the contact trench 146T and the cell insulating film 130 may be formed, and the second and third pre-cell conductive films 142p and 143p and the pre-cell line capping film 144p may be sequentially formed on the pre-conductive film. The pre-conductive film on (e.g., covering) the contact trench 146T may become the pre-direct contact 146p, and the pre-conductive film on the cell insulating film 130 may become the first pre-cell conductive film 141p. The pre-direct contact 146p and the first cell pre-conductive film 141p may be formed at the same vertical level.

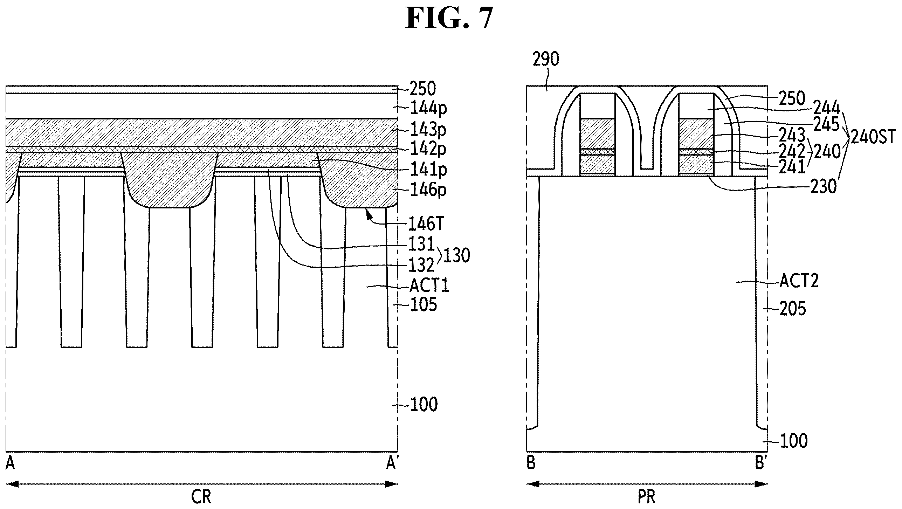

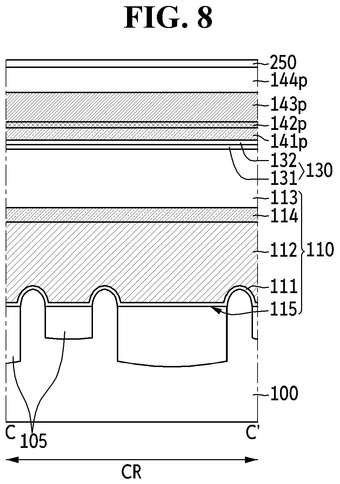

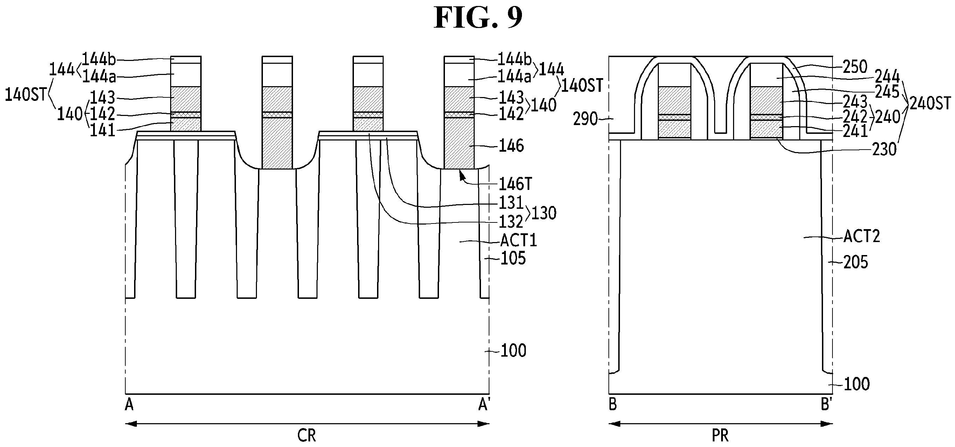

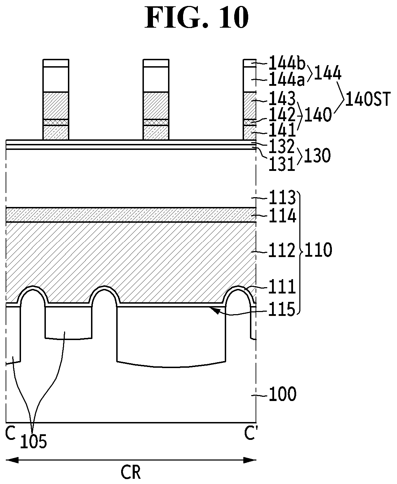

Referring to FIGS. 7 and 8, the peripheral gate structure 240ST may be formed in the peripheral area PR. The first to third peripheral conductive films 241, 242, and 243 of the peripheral gate conductive film 240 may be respectively formed by patterning the first to third pre-peripheral conductive films 241p, 242p, and 243p of FIG. 5. The peripheral gate capping film 244 may be formed by patterning the pre-peripheral gate capping film 244p in FIG. 5. For example, the peripheral gate structure 240ST may be formed before forming the bit-line structures 140ST (see FIGS. 9 and 10).

Subsequently, the lower etch stop film 250 may be formed on the pre-cell line capping film 144p and the peripheral gate structure 240ST. The lower etch stop film 250 may extend along a profile of each of the pre-cell line capping film 144p and the peripheral gate structure 240ST. For example, the lower etch stop film 250 may be formed before forming the bit-line structures 140ST (see FIGS. 9 and 10).

Subsequently, on the lower etch stop film 250, the first peripheral interlayer insulating film 290 that is in (e.g., fills) a space between the peripheral gate structures 240ST may be formed. The first peripheral interlayer insulating film 290 may not be on (e.g., may not cover) a portion of the lower etch stop film 250 disposed on the pre-cell line capping film 144p, and a portion of the lower etch stop film 250 disposed on an upper surface of the peripheral gate capping film 244 so as to be exposed. For example, the first peripheral interlayer insulating film 290 may be formed before forming the bit-line structures 140ST (see FIGS. 9 and 10).

Referring to FIGS. 9 and 10, the bit-line structure 140ST may be formed in the cell area CR.

The first to third cell conductive films 141, 142, and 143 of the cell conductive line 140 may be respectively formed by patterning the first to third pre-cell conductive films 141p, 142p, and 143p of FIGS. 7 and 8. The first cell line capping film 144a of the cell line capping film 144 may be formed by patterning the pre-cell line capping film 144p of FIGS. 7 and 8. The second cell line capping film 144b of the cell line capping film 144 may be formed by patterning the lower etch stop film 250 of the cell area CR of FIGS. 7 and 8.

In the process of forming the bit-line structure 140ST, the bit-line contact 146 may be formed.

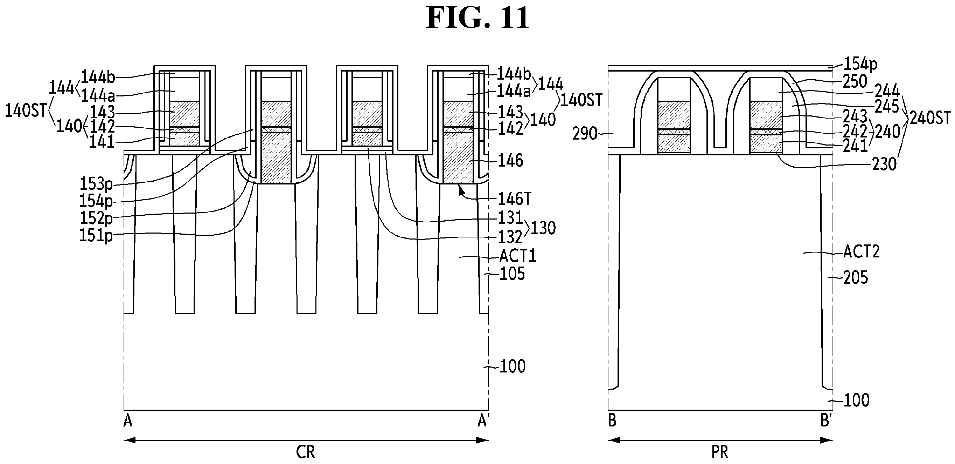

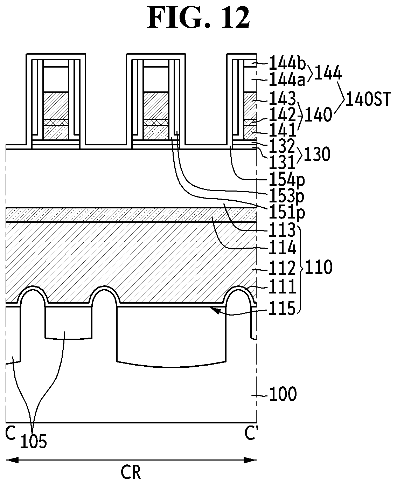

Referring to FIGS. 11 and 12, first to fourth pre-cell line spacers 151p, 152p, 153p, and 154p may be formed. The first pre-cell line spacer 151p may extend along a lower surface of the contact trench 146T and a sidewall of the bit-line structure 140ST. The second pre-cell line spacer 152p may be formed on the first pre-cell line spacer 151p and within the contact trench 146T. The third pre-cell line spacer 153p may be formed on a portion of the first pre-cell line spacer 151p disposed on the sidewall of the bit-line structure 140ST. The fourth pre-cell line spacer 154p may be formed on the upper surface of the bit-line structure 140ST, the first peripheral interlayer insulating film 290 in the peripheral area PR, and a portion of the lower etch stop film 250 not covered with the first peripheral interlayer insulating film 290 so as to be exposed.

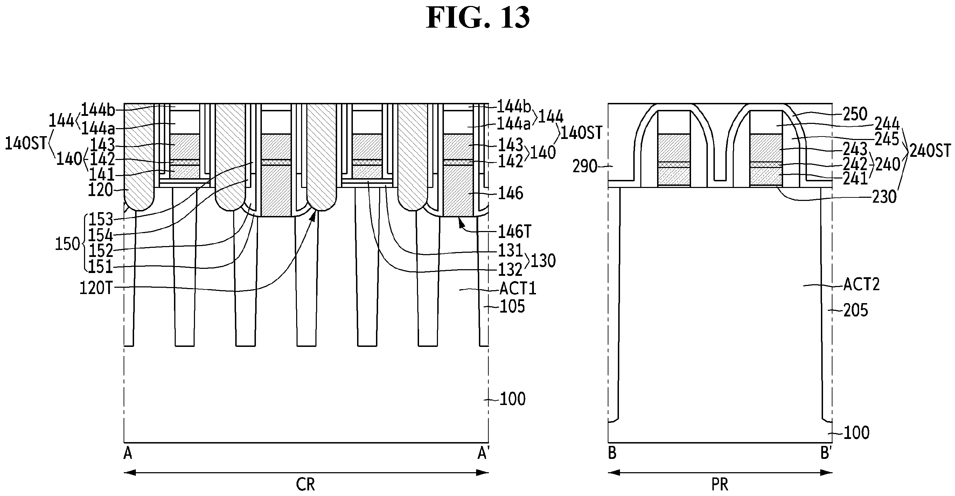

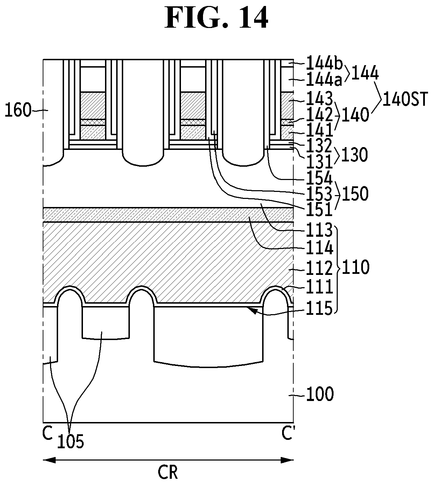

Referring to FIGS. 13 and 14, the contact trench 120T may be formed within the cell area CR. The contact trench 120T may expose the end of the cell active area ACT1. For example, the contact trench 120T may be formed between adjacent ones of the bit-line structures 140ST to expose the substrate 100 (e.g., to expose the cell active area ACT1 included in the substrate 100).

In the process of forming the contact trench 120T, the cell line spacer 150 may be formed. The cell line spacer 150 may be formed by patterning the first to fourth pre-cell line spacers 151p, 152p, 153p, and 154p in FIGS. 11 and 12. For example, the cell line spacers 150 may be formed on sidewalls of the bit-line structures 140ST. Additionally, in the process of forming the contact trench 120T, the fourth pre-cell line spacer 154p of the peripheral area PR in FIG. 11 may be removed. For example, the cell line spacers 150 may be formed before forming the storage contact 120.

Subsequently, the storage contact 120 and the fence pattern 160 may be formed. The storage contact 120 may be in (e.g., may fill) the contact trench 120T. The storage contact 120 may be connected to the cell active area ACT1. Adjacent ones of the plurality of storage contacts 120 arranged along the second direction D2 may be isolated from each other via each of the fence patterns 160 extending in parallel manner with each other and in the first direction D1. For example, the plurality of bit-line structures 140ST and the plurality of fence patterns 160 may define a plurality of isolated areas arranged in a lattice structure therebetween. The storage contacts 120 may be respectively formed within the isolation areas and may be isolated from each other. For example, the storage contact 120 may be formed in a space between ones of the cell line spacers 150 adjacent to each other in the first direction D1 and a space between ones of the cell gate structures 110 adjacent to each other in the second direction D2. The storage contact 120 may be connected to the substrate 100 (e.g., to the cell active area ACT1 included in the substrate 100).

For example, a pre-storage contact may be formed so as to be on (e.g., to cover) the cell area CR and the peripheral area PR. The pre-storage contact may be in (e.g., may fill) the contact trench 120T and may be on (e.g., may cover) the upper surface of the cell line spacer 150, the upper surface of the bit-line structure 140ST, the upper surface of the first peripheral interlayer insulating film 290, and a portion of the upper surface of the lower etch stop film 250 not covered with the first peripheral interlayer insulating film 290 so as to be exposed. An etching process may be performed on the pre-storage contact. The etching process may be, for example, an etch back process or a planarization process. The planarization process may include a chemical mechanical polishing (CMP) process. As the etching process is performed, the upper surface of the cell line spacer 150, the upper surface of the bit-line structure 140ST, the upper surface of the first peripheral interlayer insulating film 290, and the portion of the upper surface of the lower etch stop film 250 not covered with the first peripheral interlayer insulating film 290 may be exposed. The upper surface of the cell line spacer 150, the upper surface of the bit-line structure 140ST, and the upper surface of the storage contact 120 may be substantially coplanar with each other. The etching process may be performed such that the peripheral gate structure 240ST is not damaged. Additionally, the pre-storage contact may be patterned using the fence pattern 160.

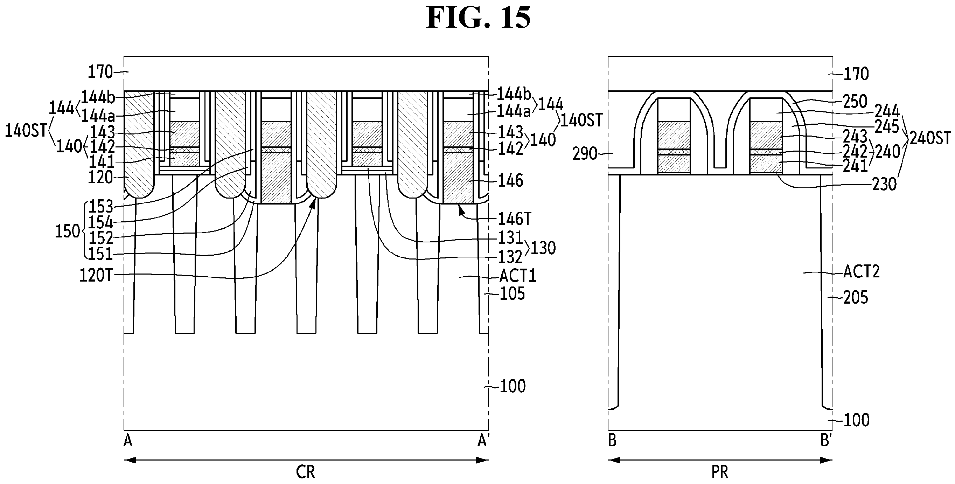

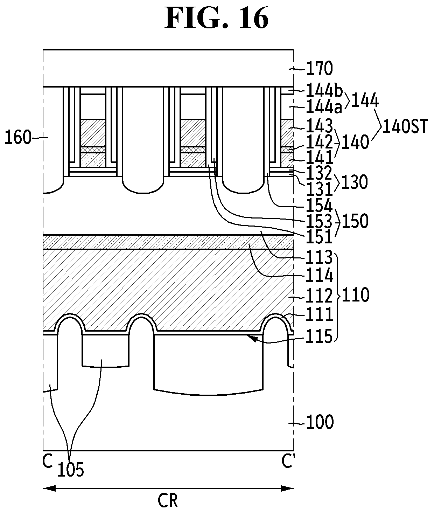

Referring to FIGS. 15 and 16, the capping pattern 170 may be formed in the cell area CR and the peripheral area PR. The capping pattern 170 may be on (e.g., may cover) the upper surface of the cell line spacer 150, the upper surface of the bit-line structure 140ST, the upper surface of the storage contact 120, the upper surface of the fence pattern 160, the upper surface of the first peripheral interlayer insulating film 290, and the portion of the upper surface of the lower etch stop film 250 not covered with the first peripheral interlayer insulating film 290 so as to be exposed. The capping pattern 170 may be formed on the peripheral gate structure 240ST.

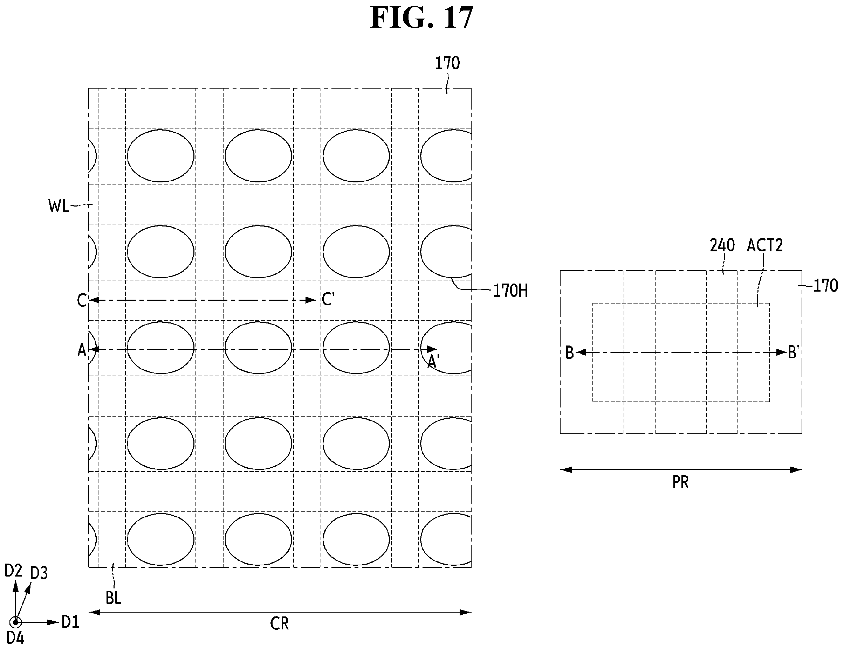

Referring to FIGS. 17 to 19, the capping pattern 170 of the cell area CR may be patterned to form the plurality of holes 170H. Each hole 170H may be formed at a location corresponding to each storage contact 120. The hole 170H exposing at least a portion of the storage contact 120 may be formed by etching the capping pattern 170 of the cell area CR. For example, the hole 170H formed by etching the capping pattern 170 may not expose the cell line spacers 150.

In some embodiments, the hole 170H may expose a portion of the upper surface of the storage contact 120. A width in the direction (for example, the first direction D1 or the second direction D2) parallel to the upper surface of the substrate 100 of the lower surface of the hole 170H may be smaller than a width in the direction (for example, the first direction D1 or the second direction D2) parallel to the upper surface of the substrate 100 of the upper surface of the storage contact 120. The cell line spacer 150 may not be exposed through the hole 170H. The capping pattern 170 may be on (e.g., may cover) the cell line spacer 150. In other words, a width W1 in the first direction D1 of the lower surface of the capping pattern 170 (e.g., in the cell area CR) may be greater than a distance W2 between the storage contacts 120 (e.g., between adjacent ones of the storage contacts 120).

In some embodiments, the side wall of the hole 170H may be inclined. The width in the direction (for example, the first direction D1 or the second direction D2) parallel to the upper surface of the substrate 100 of the hole 170H may increase as the hole 170H extends away from the substrate 100. The width of the top of the hole 170H may be larger than the width of the bottom of the hole 170H. In other words, a width in the direction (for example, the first direction D1 or the second direction D2) parallel to the upper surface of the substrate 100 of the capping pattern 170 may decrease as the capping pattern 170 extends away from the substrate 100. Therefore, since it becomes easier to fill the hole 170H, a difficulty of a process of forming the storage pad 180 may be reduced. Additionally, the hole 170H may be filled with various materials.

In some embodiments, although not specifically shown, a lower surface of the hole 170H may be disposed in the storage contact 120. In this case, a vertical level of the lower surface of the hole 170H may be lower than a vertical level of the upper surface of the storage contact 120. In other words, in some embodiments, the lower surface of the hole 170H may be closer to the substrate 100 than the upper surface of the storage contact 120 is.

In some embodiments, a process of forming the plurality of holes 170H may include using an extreme ultraviolet (EUV) process. For example, the hole 170H may have a circular shape in a plan view including the first direction D1 and the second direction D2.

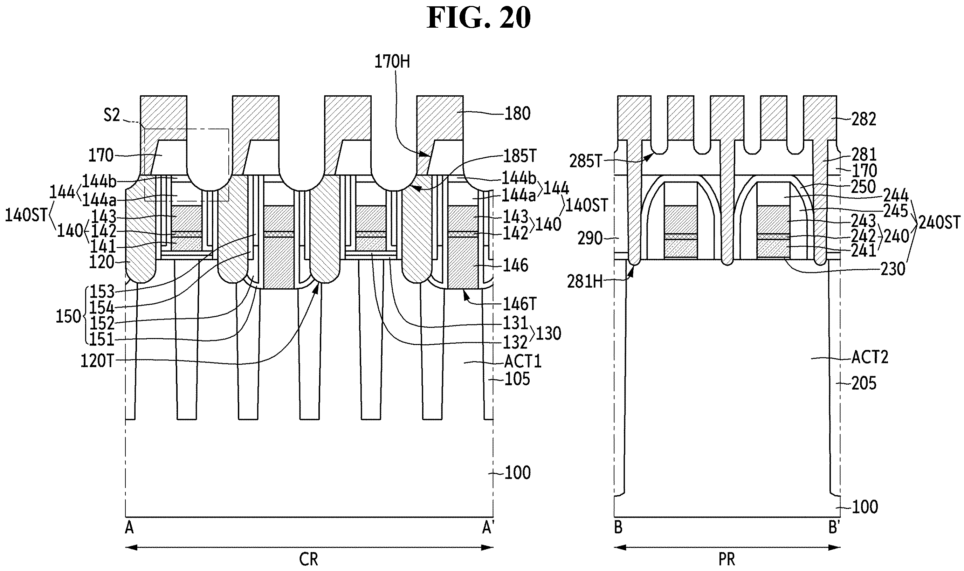

Referring to FIG. 20, a plug hole 281H may be formed in the peripheral area PR. The plug hole 281H may extend through the capping pattern 170 of the peripheral area PR, the first peripheral interlayer insulating film 290, and the lower etch stop film 250 to expose a portion of the peripheral active area ACT2.

Subsequently, the storage pad 180, the peripheral contact plug 281, and the peripheral wiring line 282 may be formed. For example, the storage pad 180 may be formed in the hole 170H, and the peripheral contact plug 281 may be formed in the plug hole 281H. The storage pad 180 may be formed on an upper surface of a portion of the capping pattern 170 in the cell area CR.

In some embodiments, the pad isolation pattern 185 and the peripheral wiring isolation pattern 285 may be formed at the same vertical level (e.g., see FIG. 3). After a pre-conductive film is formed in the peripheral area PR and the cell area CR, the pre-conductive film may be patterned to form the pad trench 185T and the wiring trench 285T. Accordingly, the peripheral wiring line 282 may be formed in the peripheral area PR and the storage pad 180 may be formed in the cell area CR. The pad trench 185T and the wiring trench 285T may be formed in the same process.

For example, the pre-conductive film may be formed so as to be in (e.g., to fill) the hole 170H and the plug hole 281H and to be on (e.g., to cover) the capping pattern 170. The pre-conductive film may be connected to the storage contact 120. The pre-conductive film may be connected to the peripheral active area ACT2. Subsequently, the pad trench 185T and the wiring trench 285T may be formed therein. The pad trench 185T may be formed in the cell area CR. The pad trench 185T may define the storage pad 180 that constitutes each of a plurality of isolated areas spaced apart from each other in the cell area CR. For example, the pad trench 185T may extend downward from an upper surface of the storage pad 180. The pad trench 185T may extend through at least a portion of the capping pattern 170. The wiring trench 285T may be formed in the peripheral area PR. The wiring trench 285T may define each of a plurality of the peripheral wiring lines 282 that are spaced apart from each other in the peripheral area PR. A portion of the pre-conductive film in (e.g., filling) the plug hole 281H may become the peripheral contact plug 281. The pre-conductive film may be patterned to form the wiring trench 285T such that the peripheral wiring line 282 may be formed. The pre-conductive film may be patterned to form the pad trench 185T such that the storage pad 180 may be formed.

Next, referring back to FIGS. 3 and 4, the pad isolation pattern 185, the peripheral wiring isolation pattern 285, the upper etch stop film 292, the data storage pattern 190 and the second peripheral interlayer insulating film 293 may be formed.

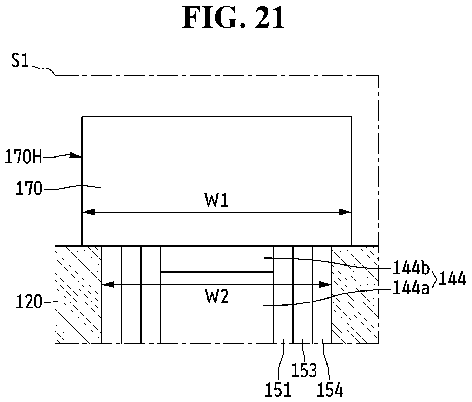

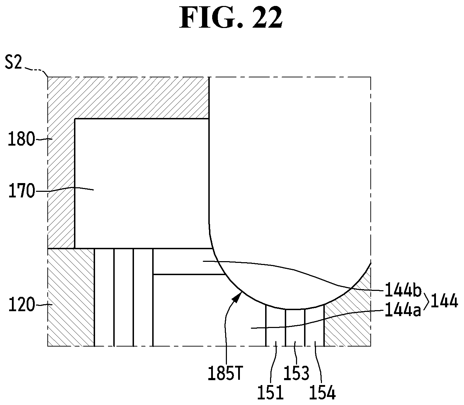

Referring to FIGS. 21 and 22, in some other embodiments, a sidewall of the hole 170H may be perpendicular to the upper surface of the substrate 100. A width in a direction (for example, the first direction D1 or the second direction D2) parallel to the upper surface of the substrate 100 of the hole 170H may be substantially constant as the hole 170H extends away from the substrate 100. A width of the top of the hole 170H may be substantially equal to a width of the bottom of the hole 170H. In other words, the width in the direction (for example, the first direction D1 or the second direction D2) parallel to the upper surface of the substrate 100 of the capping pattern 170 may be substantially constant as the capping pattern extends away from the substrate 100.

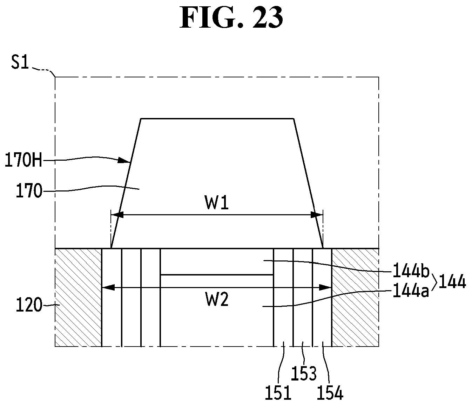

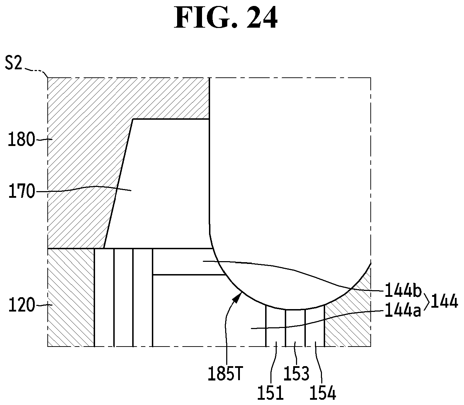

Referring to FIGS. 23 and 24, in some other embodiments, the hole 170H may expose the upper surface of the storage contact 120. A width in the direction (for example, the first direction D1 or the second direction D2) parallel to the upper surface of the substrate 100 of the lower surface of the hole 170H may be larger than a width in the direction (for example, the first direction D1 or the second direction D2) parallel to the upper surface of the substrate 100 of the upper surface of the storage contact 120. The hole 170H may expose a portion of the upper surface of the cell line spacer 150. In other words, the hole 170H formed by etching the capping pattern 170 may expose a portion of the cell line spacer 150. For example, the hole 170H may expose a portion of the upper surface of the fourth cell line spacer 154. The hole 170H may not expose the upper surface of the first and third cell line spacers 151 and 153. The capping pattern 170 may be on (e.g., may cover) a portion of the cell line spacer 150. In other words, the width W1 in the first direction D1 of the lower surface of the capping pattern 170 may be smaller than the distance W2 between the storage contacts 120 (e.g., between adjacent ones of the storage contacts 120).

In a case where the capping pattern is first formed and, subsequently, the bit-line structure 140ST and the storage contact 120 are formed, the capping pattern is formed on the pre-cell line capping film 144p and, subsequently, the pre-cell conductive films 141p, 142p, and 143p, the pre-cell line capping film 144p and the capping pattern are etched to form the bit-line structure 140ST. Due to the capping pattern, a total height of the films (the pre-cell conductive films 141p, 142p, and 143p, the pre-cell line capping film 144p and the capping pattern) to be etched may increase, such that a difficulty of the process of forming the bit-line structure 140ST may increase. In addition, because the storage contact 120 is formed in a state where a height of the bit-line structure 140ST is large, a difficulty of the process of forming the storage contact 120 may increase. In addition, since the storage pad 180 is formed on the storage contact 120 between the bit-line structures 140ST in a state where the height of the bit-line structure 140ST is large, a seam may be formed in the storage pad 180 or the storage pad 180 may insufficiently fill a space between the bit-line structures 140ST.

However, in the method for manufacturing the semiconductor memory device according to some embodiments, the bit-line structure 140ST and the storage contact 120 are formed, and subsequently, the capping pattern 170 that is on (e.g., that covers) the upper surface of the bit-line structure 140ST is formed. That is, in a state in which the capping pattern 170 is absent, the pre-cell conductive films 141p, 142p, and 143p and the pre-cell line capping film 144p may be etched to form the bit-line structure 140ST. Therefore, while a total height of the pre-cell conductive films 141p, 142p, and 143p and the pre-cell line capping film 144p is smaller, the pre-cell conductive films 141p, 142p, and 143p and the pre-cell line capping film 144p may be etched. Thus, the difficulty of the process of forming the bit-line structure 140ST may be lowered. Since the height of the bit-line structure 140ST is smaller, the bit-line structure 140ST may be prevented from warpage. Additionally, since the storage contact 120 is formed in a state in which the capping pattern 170 is absent (in a state where the bit-line structure 140ST has a smaller height), the difficulty of the process of forming the storage contact 120 may be lowered. Additionally, since it becomes easier to fill the contact trench 120T, defects in the storage contact 120 may be prevented.

Additionally, in the method for manufacturing the semiconductor memory device according to some embodiments, the capping pattern 170 and the hole 170H are formed, and, subsequently, the storage pad 180 is formed. The storage pad 180 is formed by filling the hole 170H. That is, since the hole 170H of a smaller depth is filled to form the storage pad 180, the difficulty of the process of forming the storage pad 180 may be lowered.

That is, according to the method for manufacturing the semiconductor memory device according to some embodiments, the increase in the process difficulty due to the large height of the bit-line structure 140ST may be lowered (i.e., minimized), such that the process defect is removed, and a process margin is maximized to improve the reliability of the semiconductor memory device.

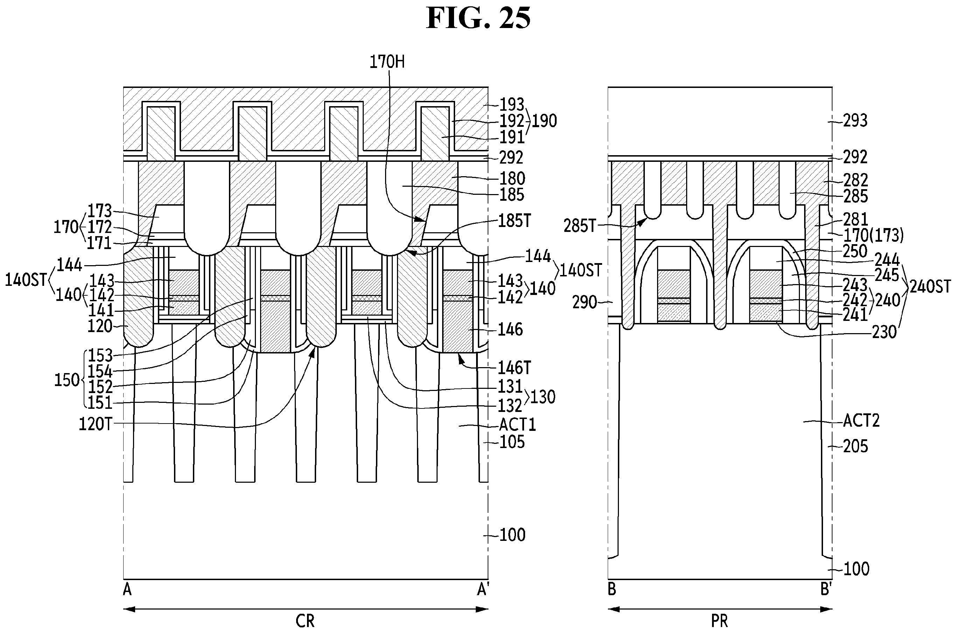

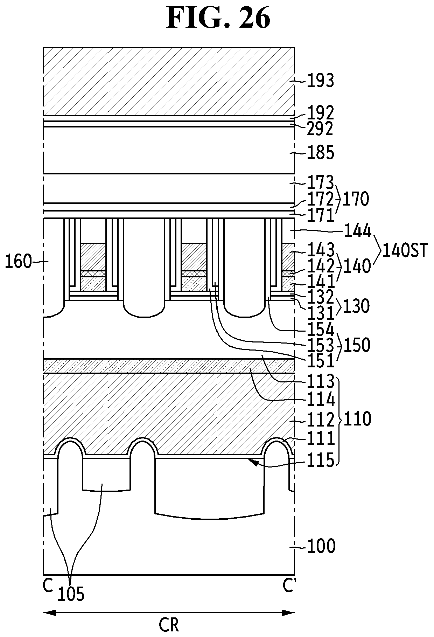

FIGS. 25 and 26 are various cross-sectional views illustrating a semiconductor memory device according to some further embodiments. For convenience of description, the components duplicate with those described above with reference to FIGS. 1 to 24 are briefly described or descriptions thereof are omitted.

Referring to FIGS. 25 and 26, in the semiconductor memory device according to some embodiments, the capping pattern 170 of the cell area CR may be embodied as a stack of multiple films.

For example, the capping pattern 170 of the cell area CR may include first to third capping patterns 171, 172, and 173 stacked on top of each other in this order (i.e., sequentially). The first capping pattern 171 may be formed at the same vertical level as a vertical level of the lower etch stop film 250. In the peripheral area PR, the capping pattern 170 may include the third capping pattern 173.

Each of the first to third capping patterns 171, 172, and 173 may include at least one of, for example, silicon nitride, silicon oxynitride, silicon carbonitride, or silicon oxycarbonitride. In some embodiments, each of the first to third capping patterns 171, 172, and 173 may include silicon nitride. When the first to third capping patterns 171, 172, and 173 are made of the same material, a boundary between the first to third capping patterns 171, 172, and 173 may not be defined. In other words, the capping pattern 170 of the cell area CR may be embodied as a monolithic film.

In some embodiments, the cell line capping film 144 may be a single film. The cell line capping film 144 may be formed at the same vertical level as the peripheral gate capping film 244.

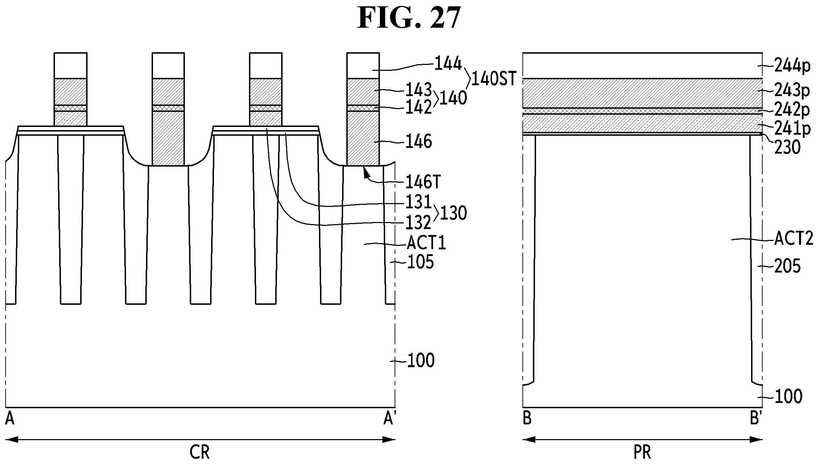

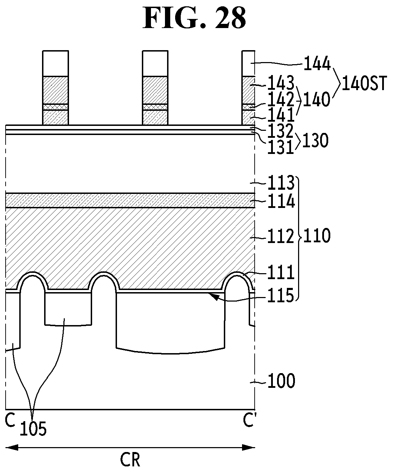

FIGS. 27 to 39 are diagrams of intermediate structures corresponding to intermediate steps for illustrating a method for manufacturing a semiconductor memory device according to some further embodiments. For convenience of description, the components duplicate with those described above with reference to FIGS. 1 to 26 are briefly described or descriptions thereof are omitted. For reference, FIGS. 27 and 28 are drawings subsequent to the steps described with reference to FIGS. 5 and 6.

A method for manufacturing a semiconductor memory device according to some embodiments may include forming the bit-line structure 140ST and the storage contact 120, and subsequently, forming the peripheral gate structure 240ST.

Referring to FIGS. 27 and 28, the bit-line structure 140ST may be formed in the cell area CR. The first to third cell conductive films 141, 142, and 143 of the cell conductive line 140 may be formed by patterning the first to third pre-cell conductive films 141p, 142p, and 143p of FIGS. 5 and 6. The cell line capping film 144 may be formed by patterning the pre-cell line capping film 144p of FIGS. 5 and 6. In the process of forming the bit-line structure 140ST, the bit-line contact 146 may be formed.

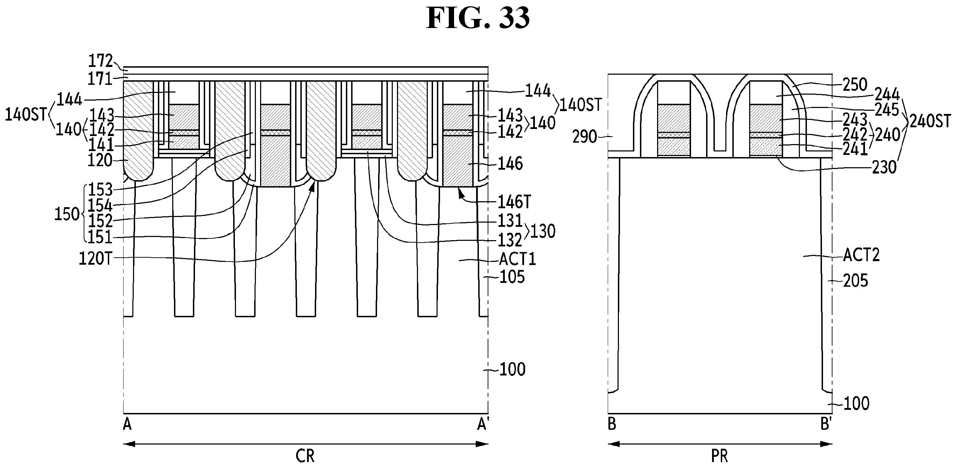

In some embodiments, the pre-cell line capping film 144p in FIGS. 5 and 6 may have a thickness optimized to form the bit-line structure 140ST. An amount of the capping pattern 170 required to later form the storage pad 180 and the pad isolation pattern 185 may be compensated for by the second and third capping patterns (172 and 173 of FIGS. 33 to 39) in the cell area CR. Therefore, the difficulty of the process of forming the bit-line structure 140ST may be lowered.

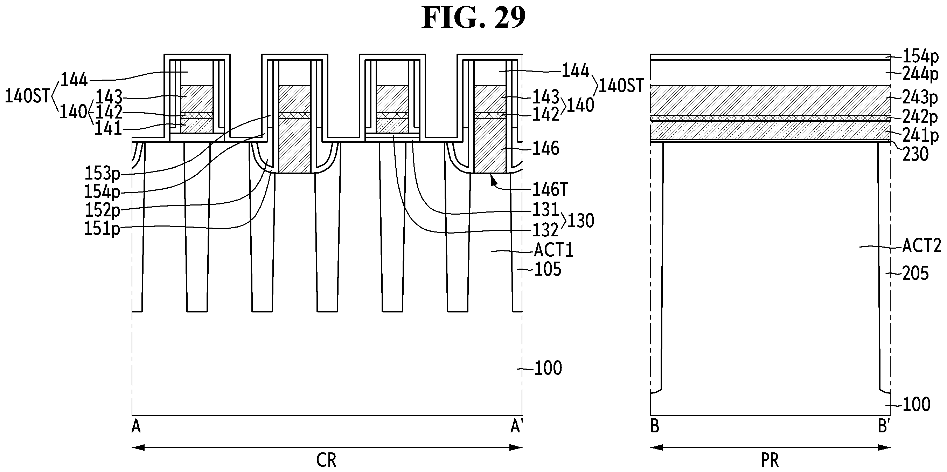

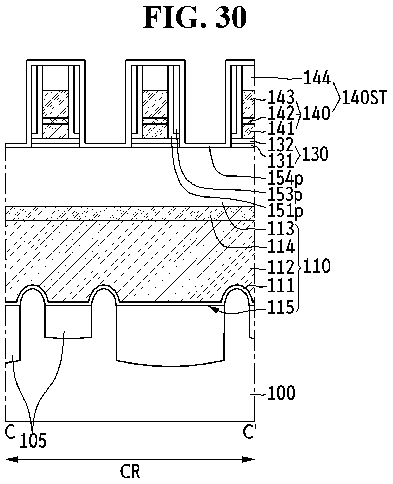

Referring to FIGS. 29 and 30, the first to fourth pre-cell line spacers 151p, 152p, 153p, and 154p may be formed. The fourth pre-cell line spacer 154p may also be formed on the upper surface of the bit-line structure 140ST and the pre-peripheral gate capping film 244p of the peripheral area PR.

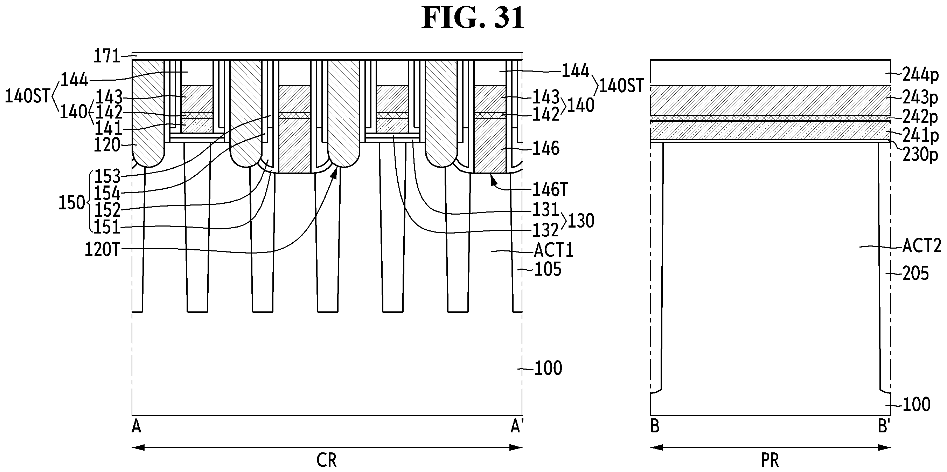

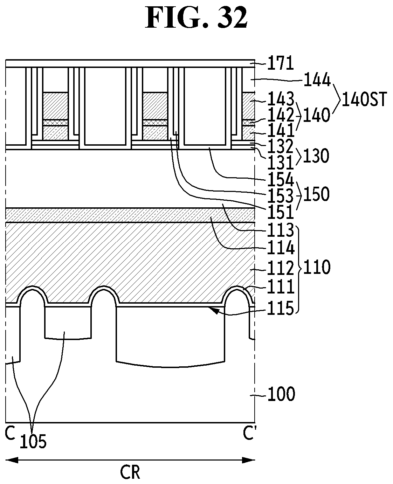

Referring to FIGS. 31 and 32, the contact trench 120T may be formed in the cell area CR. In the process of forming the contact trench 120T, the cell line spacer 150 may be formed. The cell line spacer 150 may be formed by patterning the first to fourth pre-cell line spacers 151p, 152p, 153p, and 154p in FIGS. 29 and 30. Additionally, in the process of forming the contact trench 120T, the fourth pre-cell line spacer 154p of the peripheral area PR in FIG. 29 may be removed.

Subsequently, the first capping pattern 171 may be formed in the cell area CR. The first capping pattern 171 may be on (e.g., may cover) the cell area CR but may not be on (e.g., may not cover) the peripheral area PR so as to be exposed. The first capping pattern 171 may be on (e.g., may cover) the upper surface of the cell line spacer 150, the upper surface of the storage contact 120, the upper surface of the bit-line structure 140ST, and the upper surface of the fence pattern 160.

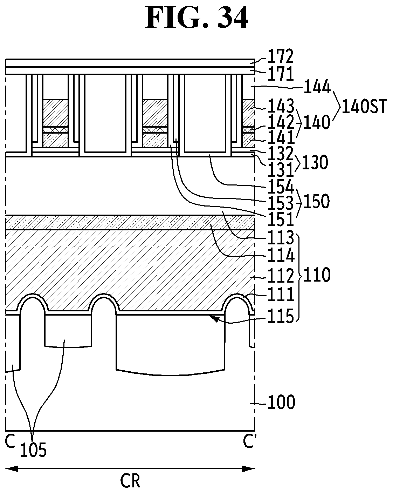

Referring to FIGS. 33 and 34, the peripheral gate structure 240ST may be formed in the peripheral area PR. The first to third peripheral conductive films 241, 242, and 243 of the peripheral gate conductive film 240 may be formed by patterning the first to third pre-peripheral conductive films 241p, 242p, and 243p of FIG. 31. The peripheral gate capping film 244 may be formed by patterning the pre-peripheral gate capping film 244p of FIG. 31. The cell area CR may be protected by the first capping pattern 171 of the cell area CR in the process of forming the peripheral gate structure 240ST. For example, the peripheral gate structure 240ST may be formed after forming the bit-line structures 140ST, and may be formed after forming the first capping pattern 171.

Subsequently, the lower etch stop film 250 may be formed on the first capping pattern 171 and the peripheral gate structure 240ST. The lower etch stop film 250 may extend along a profile of each of the first capping pattern 171 and the peripheral gate structure 240ST. The lower etch stop film 250 formed in the cell area CR is the second capping pattern 172. Subsequently, the first peripheral interlayer insulating film 290 that is in (e.g., that fills) the space between the peripheral gate structures 240ST may be formed on the lower etch stop film 250.

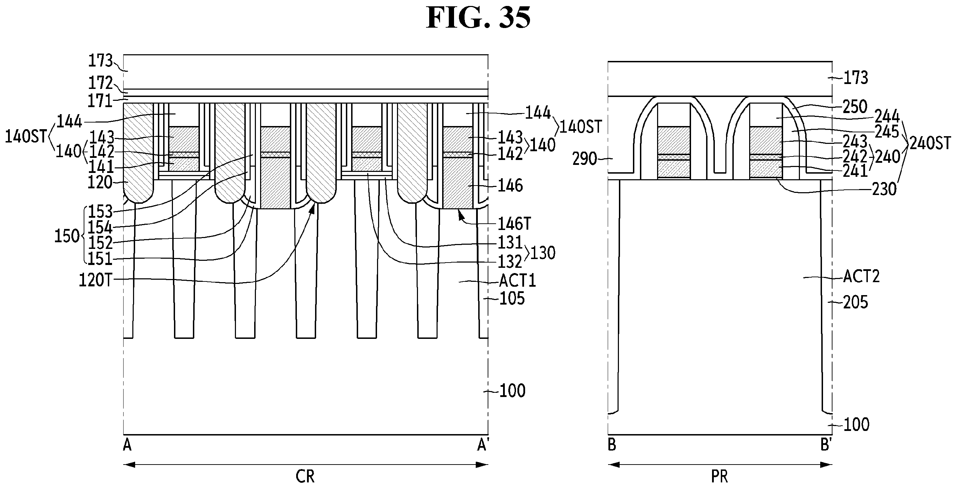

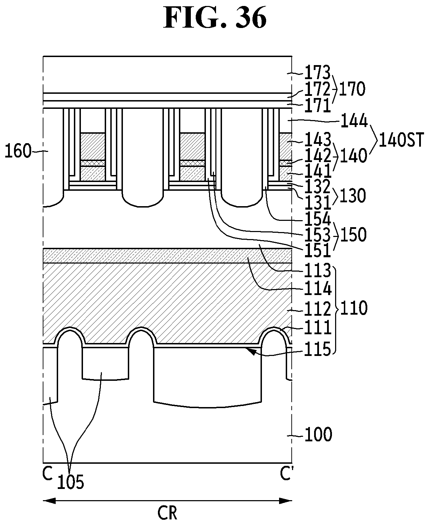

Referring to FIGS. 35 and 36, the third capping pattern 173 may be formed. The third capping pattern 173 may be formed on the second capping pattern 172. The third capping pattern 173 may be formed on the upper surface of the first peripheral interlayer insulating film 290, and the portion of the upper surface of the lower etch stop film 250 not covered with the first peripheral interlayer insulating film 290 so as to be exposed. The third capping pattern 173 may be formed on the peripheral gate structure 240ST.

For example, a thickness in the fourth direction D4 (e.g., a vertical direction) of the third capping pattern 173 may be larger than a thickness in the fourth direction D4 of the first capping pattern 171.

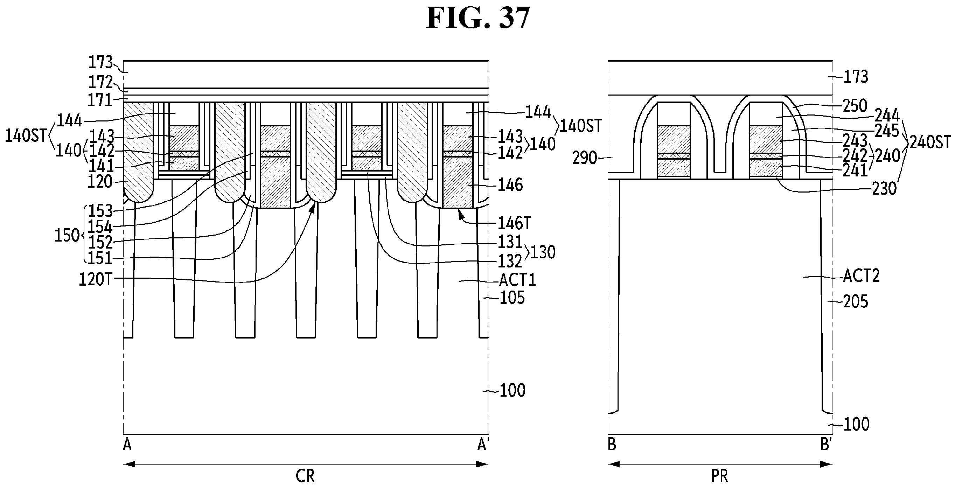

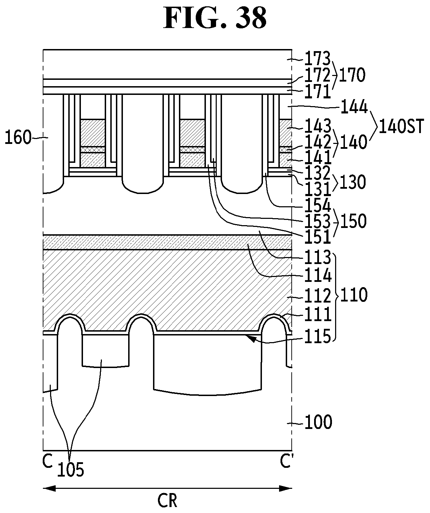

Referring to FIGS. 37 and 38, a step between the cell area CR and the peripheral area PR may be eliminated. For example, a planarization process may be performed on the third capping pattern 173. The planarization process may include the chemical mechanical polishing (CMP) process. Accordingly, the upper surface of the third capping pattern 173 of the cell area CR may be substantially coplanar with the upper surface of the third capping pattern 173 of the peripheral area PR.

In some embodiments, a thickness of the third capping pattern 173 in FIGS. 35 and 36 may be adjusted depending on the step between the cell area CR and the peripheral area PR. Additionally, the thickness of the third capping pattern 173 in FIGS. 35 and 36 may be adjusted so that the capping pattern 170 of the cell area CR has the thickness necessary to form the storage pad 180 and the pad isolation pattern 185 later.

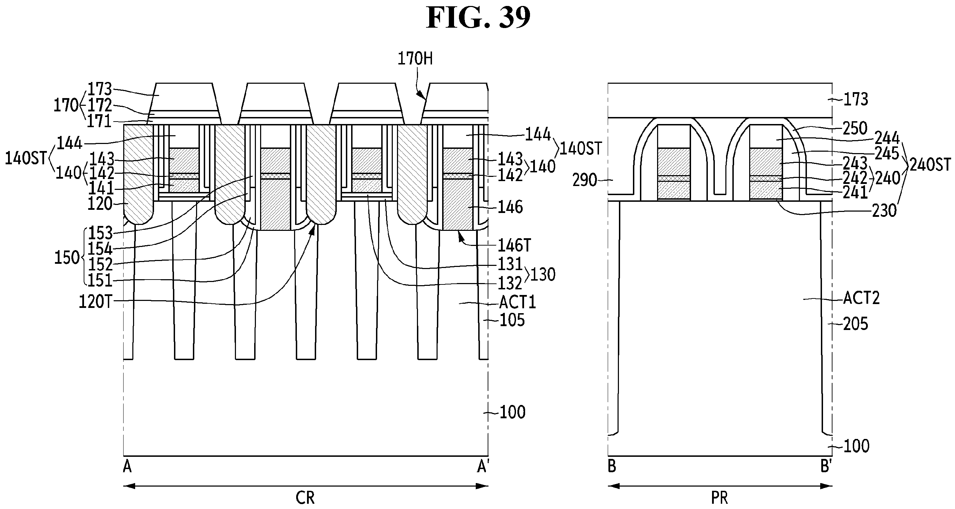

Referring to FIG. 39, the plurality of holes 170H may be formed in the cell area CR.

In some embodiments, the hole 170H may expose a portion of the upper surface of the storage contact 120, as described above with reference to FIGS. 17 to 19. In some embodiments, the hole 170H may have a sloped sidewall, as described above with reference to FIGS. 17 to 19. In some embodiments, the lower surface of the hole 170H may be disposed in the storage contact 120, as described above with reference to FIGS. 17 to 19. In some other embodiments, as described above with reference to FIGS. 21 and 22, the sidewall of the hole 170H may be perpendicular to the upper surface of the substrate 100. In some other embodiments, as described above with reference to FIGS. 23 and 24, the hole 170H may expose the upper surface of the storage contact 120. In this case, the hole 170H may expose a portion of the upper surface of the fourth cell line spacer 154, but may not expose the upper surface of each of the first and third cell line spacers 151 and 153.

Next, referring back to FIGS. 25 and 26, the storage pad 180, the pad isolation pattern 185, the peripheral contact plug 281, the peripheral wiring line 282, the peripheral wiring isolation pattern 285, the upper etch stop film 292, the data storage pattern 190 and the second peripheral interlayer insulating film 293 may be formed.

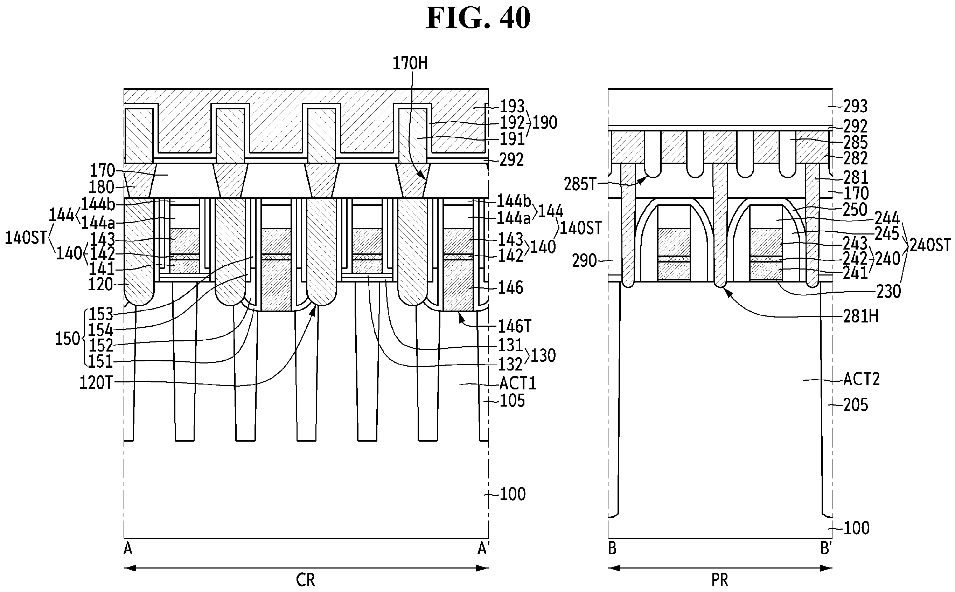

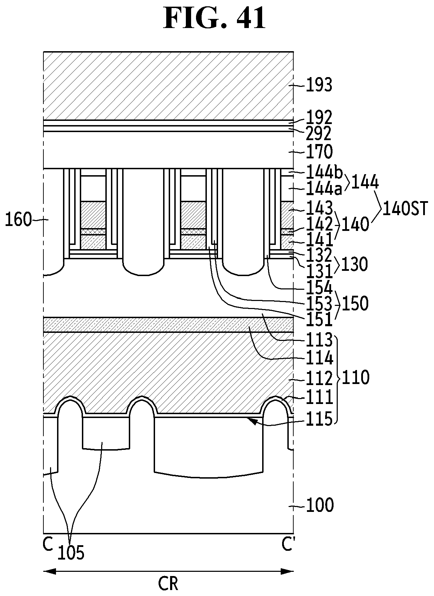

FIGS. 40 and 41 are various cross-sectional views illustrating a semiconductor memory device according to some further embodiments. For convenience of description, the components duplicate with those as described above with reference to FIGS. 1 to 39 are briefly described or descriptions thereof are omitted.

Referring to FIGS. 40 and 41, the storage pads 180 may be isolated from each other via the capping pattern 170 in the semiconductor memory device according to some embodiments. The upper surface of the storage pad 180 and the upper surface of the capping pattern 170 may be substantially coplanar with each other. The upper etch stop film 292 may be disposed on the capping pattern 170 and the storage pad 180.

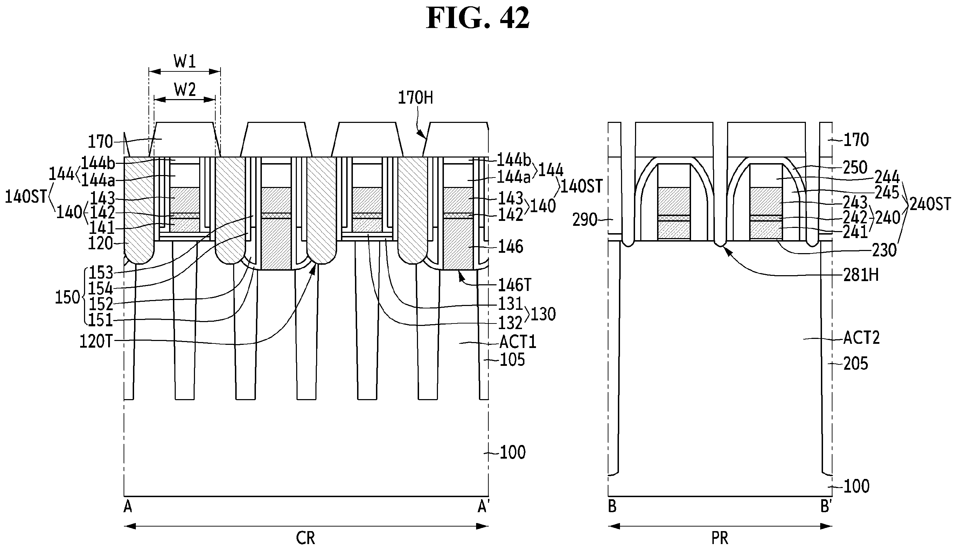

FIGS. 42 to 44 are diagrams of intermediate structures corresponding to intermediate steps for illustrating a method for manufacturing a semiconductor memory device according to some further embodiments. For convenience of description, the components duplicate with those as described above with reference to FIGS. 1 to 41 are briefly described or descriptions thereof are omitted. FIG. 42 may be a drawing subsequent to the steps described with reference to FIGS. 17 to 19. In other words, the capping pattern 170 may be embodied as a single film. In other embodiments, FIG. 42 may be a drawing subsequent to the steps described with reference to FIG. 39. That is, the capping pattern 170 may include the first to third capping patterns 171, 172, and 173.

Referring to FIG. 42, the plug hole 281H may be formed in the peripheral area PR. In some embodiments, the hole 170H may expose a portion of the upper surface of the storage contact 120, as described above with reference to FIGS. 17 to 19. In some embodiments, the hole 170H may have the sloped sidewall, as described above with reference to FIGS. 17 to 19. In some embodiments, the lower surface of the hole 170H may be disposed in the storage contact 120, as described above with reference to FIGS. 17 to 19. In some other embodiments, as described above with reference to FIGS. 21 and 22, the sidewall of the hole 170H may be perpendicular to the upper surface of the substrate 100. In some other embodiments, as described above with reference to FIGS. 23 and 24, the hole 170H may expose the upper surface of the storage contact 120. In this case, the hole 170H may expose a portion of the upper surface of the fourth cell line spacer 154, but may not expose the upper surface of each of the first and third cell line spacers 151 and 153.

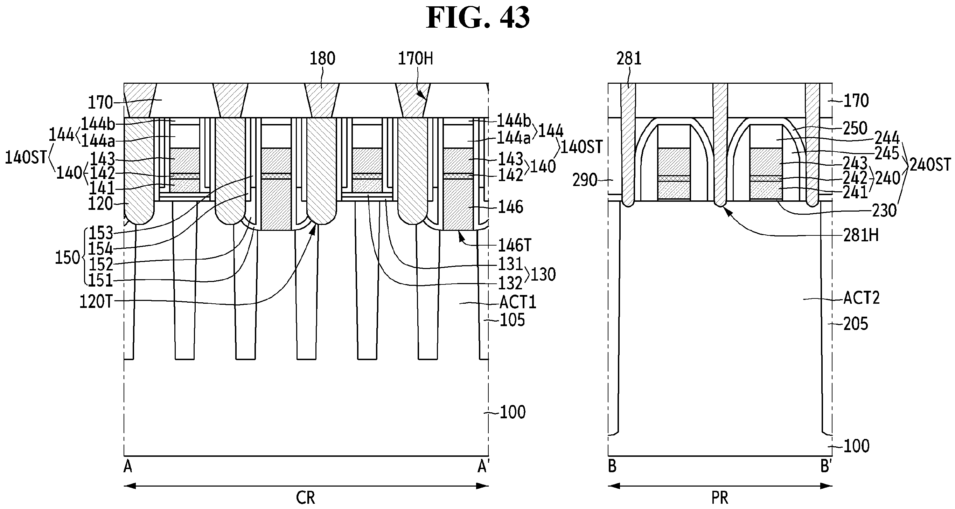

Referring to FIG. 43, the storage pad 180 and the peripheral contact plug 281 may be formed.

For example, the pre-conductive film may be formed so as to be in (e.g., to fill) the hole 170H and the plug hole 281H and to be on (e.g., to cover) the capping pattern 170. An etching process may be performed on the pre-conductive film to expose the capping pattern 170. The etching process may be, for example, an etch back process or a planarization process. A portion of the pre-conductive film in (e.g., filling) the hole 170H may become the storage pad 180. A portion of the pre-conductive film in (e.g., filling) the plug hole 281H may become the peripheral contact plug 281.

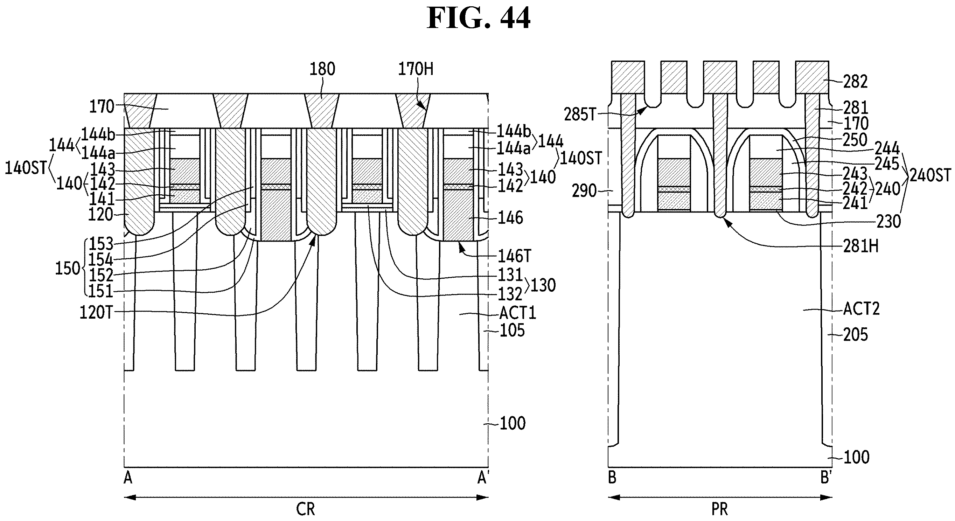

Referring to FIG. 44, the peripheral wiring line 282 may be formed in the peripheral area PR. For example, the pre-conductive film on (e.g., covering) the peripheral contact plug 281 and the capping pattern 170 may be formed on the peripheral area PR. The wiring trench 285T that isolates portions of the pre-conductive film from each other may be formed in the peripheral area PR. Each of the portions of the pre-conductive film isolated from each other via the wiring trench 285T may become the peripheral wiring line 282. A border between the peripheral contact plug 281 and the peripheral wiring line 282 may not be defined.

Next, referring back to FIGS. 40 and 41, the peripheral wiring isolation pattern 285, the upper etch stop film 292, the data storage pattern 190 and the second peripheral interlayer insulating film 293 may be formed.

In some embodiments, the storage pad 180 and the peripheral wiring line 282 may be formed in separate processes. The hole 170H may be formed in the cell area CR, and, subsequently, the storage pad 180 may be formed to be in (e.g., to fill) the hole 170H. The pre-conductive film may be formed in the peripheral area PR, and, subsequently, the pre-conductive film may be patterned to form the wiring trench 285T. Accordingly, the peripheral wiring line 282 may be formed in the peripheral area PR. The hole 170H and the wiring trench 285T may be formed in separate processes.

Although example embodiments of the present disclosure have been described above with reference to the accompanying drawings, the present disclosure is not limited to the above-described embodiments, and may be implemented in various different forms. A person skilled in the art will appreciate that the present disclosure may be practiced in other concrete forms without changing the scope of the present disclosure. Therefore, it should be appreciated that the example embodiments as described above are not restrictive but illustrative in all respects.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

Examples are set out in the following numbered clauses:
1. A method for manufacturing a semiconductor memory device, the method comprising:
   providing a substrate including a cell area and a peripheral area;
   forming a peripheral gate structure on the peripheral area of the substrate;
   forming bit-line structures on the cell area of the substrate, wherein the bit-line structures are arranged in a first direction and extend in a second direction intersecting the first direction;
   forming cell line spacers on sidewalls of the bit-line structures;
   forming a storage contact in a space between ones of the cell line spacers adjacent to each other in the first direction, wherein the storage contact is electrically connected to the substrate;
   forming a capping pattern on at least one of the bit-line structures, at least one of the cell line spacers, the storage contact, and the peripheral gate structure;
   patterning the capping pattern to form a hole exposing at least a portion of the storage contact; and
   forming a storage pad in the hole.
2. The method of clause 1, wherein the forming of the peripheral gate structure is performed before forming the bit-line structures.
3. The method of clause 2, further comprising:
   forming an etch stop film extending along the peripheral gate structure before forming the bit-line structures; and
   forming a peripheral interlayer insulating film on the etch stop film before forming the bit-line structures, wherein the peripheral interlayer insulating film does not cover a portion of the etch stop film that is on an upper surface of the peripheral gate structure.
4. The method of any preceding clause, wherein the forming of the peripheral gate structure is performed after forming the bit-line structures.
5. The method of clause 4, wherein the forming of the capping pattern includes:
   forming a first capping pattern on the at least one of the bit-line structures, the at least one of the cell line spacers, and the storage contact; and
   forming a second capping pattern on the first capping pattern and the peripheral gate structure.
6. The method of clause 5, wherein the forming of the peripheral gate structure is performed after forming the first capping pattern.
7. The method of clause 5 or clause 6, wherein the forming of the capping pattern further includes performing a planarization process on the second capping pattern.
8. The method of any preceding clause, wherein a width of the hole increases as the hole extends away from the substrate.
9. A method for manufacturing a semiconductor memory device, the method comprising:
   forming bit-line structures on a substrate, wherein the bit-line structures are arranged in a first direction and extend in a second direction intersecting the first direction;
   forming a contact trench between ones of the bit-line structures to expose the substrate;
   forming a storage contact in the contact trench;
   forming a capping pattern on at least one of the bit-line structures and the storage contact;
   patterning the capping pattern to form a hole exposing at least a portion of the storage contact; and
   forming a storage pad in the hole.
10. The method of clause 9, wherein a sidewall of the hole is inclined.
11. The method of clause 9 or clause 10, wherein a sidewall of the hole is perpendicular to an upper surface of the substrate.
12. The method of any of clauses 9 to 11, wherein the forming of the capping pattern includes sequentially forming a first capping pattern and a second capping pattern on the at least one of the bit-line structures and the storage contact.
13. The method of any of clauses 9 to 12, wherein an upper surface of the storage contact is coplanar with upper surfaces of the bit-line structures.
14. The method of any of clauses 9 to 13, further comprising forming cell line spacers on sidewalls of the bit-line structures before forming the storage contact,
   wherein the patterning of the capping pattern to form the hole includes forming the hole so that the hole does not expose the cell line spacers.
15. The method of any of clauses 9 to 14, further comprising forming cell line spacers on sidewalls of the bit-line structures before forming the storage contact,
   wherein the patterning of the capping pattern to form the hole includes forming the hole so that the hole exposes a portion of at least one of the cell line spacers.
16. The method of any of clauses 9 to 15, wherein the hole is formed using an extreme ultraviolet (EUV) process.
17. The method of any of clauses 9 to 16, wherein a lower surface of the hole is closer to the substrate than an upper surface of the storage contact is.
18. The method of any of clauses 9 to 17, wherein the storage pad is in contact with the capping pattern.
19. A method for manufacturing a semiconductor memory device, the method comprising:
   providing a substrate including a cell area and a peripheral area;
   forming a peripheral gate structure on the peripheral area of the substrate;
   forming cell gate structures in the cell area of the substrate, wherein the cell gate structures extend in a first direction and are arranged in a second direction intersecting the first direction;
   forming bit-line structures on the cell area of the substrate, wherein the bit-line structures are arranged in the first direction and extend in the second direction;
   forming cell line spacers on sidewalls of the bit-line structures;
   forming a storage contact in a space between ones of the cell gate structures adjacent to each other in the second direction and a space between ones of the cell line spacers adjacent to each other in the first direction, wherein the storage contact is electrically connected to the substrate;
   forming a capping pattern on at least one of the bit-line structures, at least one of the cell line spacers, the storage contact, and the peripheral gate structure;
   patterning the capping pattern to form a hole exposing at least a portion of the storage contact;
   forming a storage pad in the hole and on an upper surface of a portion of the capping pattern in the cell area;
   forming a pad isolation pattern adjacent to the storage pad; and
   forming a data storage pattern on the storage pad to be electrically connected to the storage pad.
20. The method of clause 19, wherein the forming of the pad isolation pattern includes:
   forming a pad isolation trench extending downward from an upper surface of the storage pad and extending through at least a portion of the capping pattern; and
   forming the pad isolation pattern in the pad isolation trench.

## Claims

1. A method for manufacturing a semiconductor memory device, the method comprising:
providing a substrate including a cell area and a peripheral area;
forming a peripheral gate structure on the peripheral area of the substrate;
forming bit-line structures on the cell area of the substrate, wherein the bit-line structures are arranged in a first direction and extend in a second direction intersecting the first direction;
forming cell line spacers on sidewalls of the bit-line structures;
forming a storage contact in a space between ones of the cell line spacers adjacent to each other in the first direction, wherein the storage contact is electrically connected to the substrate;
forming a capping pattern on at least one of the bit-line structures, at least one of the cell line spacers, the storage contact, and the peripheral gate structure;
patterning the capping pattern to form a hole exposing at least a portion of the storage contact; and
forming a storage pad in the hole.

2. The method of claim 1, wherein the forming of the peripheral gate structure is performed before forming the bit-line structures.

3. The method of claim 2, further comprising:
forming an etch stop film extending along the peripheral gate structure before forming the bit-line structures; and
forming a peripheral interlayer insulating film on the etch stop film before forming the bit-line structures, wherein the peripheral interlayer insulating film does not cover a portion of the etch stop film that is on an upper surface of the peripheral gate structure.

4. The method of any preceding claim, wherein the forming of the peripheral gate structure is performed after forming the bit-line structures.

5. The method of claim 4, wherein the forming of the capping pattern includes:
forming a first capping pattern on the at least one of the bit-line structures, the at least one of the cell line spacers, and the storage contact; and
forming a second capping pattern on the first capping pattern and the peripheral gate structure.

6. The method of claim 5, wherein the forming of the peripheral gate structure is performed after forming the first capping pattern.

7. The method of claim 5 or claim 6, wherein the forming of the capping pattern further includes performing a planarization process on the second capping pattern.

8. The method of any preceding claim, wherein a width of the hole increases as the hole extends away from the substrate.

9. A method for manufacturing a semiconductor memory device, the method comprising:
forming bit-line structures on a substrate, wherein the bit-line structures are arranged in a first direction and extend in a second direction intersecting the first direction;
forming a contact trench between ones of the bit-line structures to expose the substrate;
forming a storage contact in the contact trench;
forming a capping pattern on at least one of the bit-line structures and the storage contact;
patterning the capping pattern to form a hole exposing at least a portion of the storage contact; and
forming a storage pad in the hole.

10. The method of claim 9, wherein a sidewall of the hole is inclined.

11. The method of claim 9 or claim 10, wherein a sidewall of the hole is perpendicular to an upper surface of the substrate.

12. The method of any of claims 9 to 11**,** wherein the forming of the capping pattern includes sequentially forming a first capping pattern and a second capping pattern on the at least one of the bit-line structures and the storage contact.

13. The method of any of claims 9 to 12, wherein an upper surface of the storage contact is coplanar with upper surfaces of the bit-line structures.

14. The method of any of claims 9 to 13, further comprising forming cell line spacers on sidewalls of the bit-line structures before forming the storage contact,
wherein the patterning of the capping pattern to form the hole includes forming the hole so that the hole does not expose the cell line spacers.

15. The method of any of claims 9 to 14, further comprising forming cell line spacers on sidewalls of the bit-line structures before forming the storage contact,
wherein the patterning of the capping pattern to form the hole includes forming the hole so that the hole exposes a portion of at least one of the cell line spacers.
